# EUROPEAN PATENT APPLICATION

(11) **EP 2 436 510 A1**
(43) Date of publication of application: **04.04.2012**
(21) Application number: 10186358.7
(22) Date of filing: 04.10.2010
(51) Int. Cl.: B29C 67/00, G03F 7/00, G03F 7/004

(54) **System and resin for rapid prototyping**

(71) Applicant: 3D Systems, Inc., Rock Hill, SC 29730 (US)
(72) Inventor: The designation of the inventor has not yet been filed
(74) Representative: von Kreisler Selting Werner

(57) **Abstract**

A system and a resin relating to rapid prototyping.
The system comprises:
(a) an apparatus for producing a three-dimensional object from a light-sensitive material, wherein input optics (IO) and output optics (OO) facilitates transmission of light emitted from an illumination source via individually controllable light modulators (LM) of spatial light modulator (SLM) to an illumination area (IA), wherein said output optics (OO) enable focusing of the pattern of light from spatial light modulators (SLM) on an illumination area (IA); and
(b) a photocurable resin composition comprising:
(A) at least one urethane acrylate or methacrylate component, or any mixture thereof;
(B) at least one monofunctional acrylate, methacrylate, vinylamide, acrylamide or methacrylamide component, preferably with a viscosity below 100 mPa**·**s at 30°C, or any mixture thereof;
(C) at least one photo initiator, or any mixture thereof.

## Description

### Field of the invention

The present invention relates to a system and a resin for rapid prototyping and manufacturing of three-dimensional objects by additive treatment of cross-sections.

### Background

In three-dimensional rapid prototyping, it is important that the optics of the exposure system is not contaminated from contact with the light-sensitive material, which could possibly cause time-intensive cleaning or even replacement. Hence typically a relatively large distance between the output optics and the illumination area is preferred in order to avoid risk of contact between the exposure system and the light-sensitive material.

A high intensity laser spot is therefore conventionally used to irradiate the surface of a layer of a liquid curable light sensitive material according to a predefined pattern, so as to generate layer wise the required solid three-dimensional objects. After this first curing with the laser, the solidified object exhibits a so called green strength, i.e. a strength enabling the article to be self-supporting. Later, such object is post-cured with high intensity ultraviolet (UV) lamps to achieve its optimal mechanical properties.

The process of irradiating the surface of the photo curable liquid with a high energy laser spot does not allow, however, large surfaces to be cured fast and with accuracy. Furthermore, the delivery of a high amount of energy in a short time on a very small surface via a laser beam produces high thermal and mechanical stresses in the material, leading to high shrinkage and curling. In addition, a laser emits only at a very specific wavelength, at which only few specific photo initiators are active and can be used.
If incoherent UV light sources are to be used instead of lasers, said sources will exhibit necessarily lower radiation intensity. Masks with low intensity incoherent UV light sources distributed over a large surface must therefore be introduced (WO 00/21735, EP 1250997).

The use of such equipments, however, causes the problem that such non-coherent low intensity radiation cannot achieve the same curing speeds as high intensity laser radiation and requires the use of much faster-curing resin compositions to provide sufficient green strength to enable the article to be self-supporting, while being built and before a final UV flood cure following removal from the bath in which it is built. WO 2005/092598 describes acrylic based formulations with high curing speed.

However, the fast-curing polymers tend to be brittle and shrink substantially on curing, thereby degrading the accuracy of the model and causing parts of the model to curl.

The problem to be solved by the present invention is to provide a system for rapid prototyping able to produce 3D objects with large cross-sections in short time with high accuracy, whereby the produced articles exhibit good mechanical properties, high tensile strength, high toughness, high Tg and low curling and shrinkage.

The problem has been solved according to the features of independent claims 1 and 8.

### Description of the invention

### System

The invention relates to a system for producing a three-dimensional object from a light-sensitive material, said system comprising:
an exposure system with an illumination source,
a control unit,
whereby said exposure system comprises:
   at least one spatial light modulator with a plurality of individually controllable light modulators,
   input optics optically coupled to said at least one spatial light modulator,
   output optics optically coupled to said at least one spatial light modulator,
   wherein said input optics and output optics facilitates transmission of light emitted from said illumination source via said individually controllable light modulators of said spatial light modulator to an illumination area,
   wherein said spatial light modulator enables an establishment of a pattern of the light transmitted through said input optics, according to control signals originating from said control unit,
   wherein said output optics enable focusing of the pattern of light from said at least one spatial light modulator on an illumination area.

The system comprises additionally as a light sensitive material a photocurable resin composition comprising:
(A) at least one urethane acrylate or methacrylate component,
(B) at least one monofunctional acrylate, methacrylate, vinylamide, acrylamide or methacrylamide component, preferably with a viscosity below 100 mPa·s at 30°C,
(C) at least one photo initiator.

According to a preferred embodiment of the invention, the distance d between the output optics and the illumination area is between 0.5 and 20 mm and/or the illumination source generates incoherent light.

In a further advantageous embodiment of the invention, the apparatus comprises a scanning bar which facilitates that the exposure system can be moved and scanned across the surface of the light-sensitive material in order to illuminate and irradiate the desired portions of said light-sensitive material.

In three-dimensional rapid prototyping, if the output optics of the exposure system is just shortly in contact with the light-sensitive material, this may cause contamination of the output optics such that the output optics needs time-intensive cleaning or even replacement. Hence typically a relatively large distance between the output optics and the illumination area is preferred in order to avoid risk of contact between the exposure system and the light-sensitive material.

With such arrangements even small inaccuracies between the directions of individual light beams may be a serious problem and may cause some voxels to deviate from the intended position. In order to decrease the troubles with alignment of multiple beams, significant effort has been put into improving the alignment through modification of the design of the optics. Even though improvements have been observed in this way, there is a need for even better alignment of the individual light beams.

According to a preferred embodiment of the present invention it has been shown that advantageous reductions of adverse consequences of misalignment can be observed by lowering the distance between the output optics and the light-sensitive material to values between 0.5 and 20 mm. This is made possible through the use of output optics with characteristics such that the individual light beams are focused at a suitable low distance from the part of the output optics closest to the light-sensitive material. Hereby production costs in the design of the optics may be reduced without risking the efficiency of the apparatus. The foci from the light beams together establish an illumination area, which during manufacturing will at least partly flush with the upper surface of the light-sensitive material.

Furthermore, by lessening the distance between output optics and light-sensitive material, further beneficial advantages are seen as well. A larger part of the intensity of the light is transferred to the light-sensitive material, which facilitates a faster solidification of the illuminated voxels and thus in turn facilitates a faster scanning process. Hereby a more efficient three-dimensional object manufacturing is obtained.

20 mm has been established as the largest distance where the advantageous above-mentioned results may be obtained. 0.5 mm has been established as the shortest applicable distance without having too high risk of contact with the resin.

It has been observed according to embodiments of the present invention that other means may be used to avoid contact between the exposure system and the light-sensitive material, whereby the previously feared problems with low distances need not cause that such distances are not used.

The illumination source of the present invention can emit radiation in the range from deep UV to far IR, e.g. from 200 nm to 100000 nm. The term light applies therefore to radiation in the range from deep UV to far IR, e.g. from 200 nm to 100000 nm. Applications using stereo lithographic baths of curable liquid resins are preferably carried out in the ultra violet energy range with wavelength from 200 nm up to 500 nm.

In a preferred embodiment of the invention, the apparatus of the system further comprises a vat for containing the light-sensitive material. However, roll-to-roll web deposition without a vat may be used as well.
The system according to the present invention preferably comprises a vat comprising the light-sensitive material, i.e. a curable resin composition, in an amount so that the surface of said light-sensitive material substantially coincides with the illumination area.

The preferred distance between said output optics and said surface of said light-sensitive material is in this case between 0.5 mm and 20 mm, preferably between 1 mm and 10 mm.

With a low distance between output optics and illumination area, the system must cure the surface of the bath of the curable resin composition with a relatively large illumination area generated by a low-energy incoherent light.

As previously mentioned, the exposure system may move above the resin with a small distance when it is performing a scan to expose the surface of the resin. Due to this very small distance there is a risk of contamination with resin on the bottom surface of the exposure system during the scan across the resin surface. Such contamination may e.g. stems from parts of the built product, which during manufacturing may protrude slightly from the surface. This may e.g. be caused by the fact that a recoater accidentally touches the part on the building plate, or, for some resins, that stress in the already built lower-laying layers may cause unevenness of the built surface of the previous layer. The contamination may also arise due to poor layer quality as a result of recoating, for example, parts including trapped volumes and large flat areas.

If the exposure system touches a protruding part the bottom surface of the exposure system will be contaminated with resin. Consequently the surface must be cleaned from resin before the exposure can be resumed, and the cleaning is a time consuming and expensive process. Furthermore there is a risk of contamination or damage to the microoptics and SLM-modules in the exposure system.

As a consequence, there is a need for avoiding or decreasing contamination on the bottom surface.
According to a preferred embodiment of the present invention, the system of the present invention therefore comprises at least one releasable protective window between the output optics and the illumination area.

The present rapid prototyping system is capable of illumination with multiple beams, where the multiple beams are desired to be protected and hence some kind of protection is desired. However, the inclusion of a protective window in the path of the multiple beams introduces possible troublesome alignment issues as light propagating through different media will tend to loose intensity and the light beams will be displaced when travelling through the interface between different media.

Displacement of light beams due to media transitions may be problematic in any kind of rapid prototyping apparatus; however, the displacement is especially problematic when a multiple beam apparatus is used in comparison to e.g. a single beam laser system, where issues concerning individual deviating displacements between different beams do not arise.

According to the present invention it has been observed that troubles with light travelling through a protective window may be avoided by moving the exposure system close to the light-sensitive material. For example, it may be advantageous when the distance from the output optics is less than 10 mm from the light-sensitive material.

According to embodiments of the invention, the protective window is releasable, in order to facilitate an easy replacement of the protective window if the protective window has been contaminated or greased.

Alternative and additional methods are possible to avoid or decrease contamination on the bottom surface and in particular to avoid collision between the exposure system and possible protrusions in the resin.

The apparatus of the system according to the present invention may comprise preferably at least one collision-preventing detection system for detecting obstacles between the illumination area and the output optics.

In three-dimensional rapid prototyping, if e.g. the output optics of the exposure system is just shortly in contact with e.g. obstacles, this may cause contamination of the output optics such that the output optics needs time-intensive cleaning or even replacement.

Hence a need exists to aid in preventing contact between parts of the exposure system and obstacles, such as the light-sensitive material or protrusions from the vat.

An important feature of the preferred embodiment of the present invention is that it is a collision-preventing detection system. I.e. a possible future collision is detected before it actually occurs, which means that neither the exposure system nor any other component of the apparatus is damaged or contaminated due to e.g. an obstacle protruding from the surface of the vat.

In this way, the time wasted on stopping the system may be highly reduced in that an obstacle protruding from the surface of the vat may be detected and removed without contaminating the apparatus as compared to prior art, where an obstacle may cause contamination of the apparatus resulting in a time-consuming cleaning process or alternatively an expensive replacement of at least a part of the elements of the apparatus.

The collision-preventing detection system according to the present invention is especially advantageous in exposure systems, where the distance between the exposure system and the surface of the light-sensitive material is kept relatively low, for example between 0.5 and 20 mm. This means that even very small protrusions from the surface may be problematic and must be detected in time.

In an embodiment of the invention, said collision-preventing detection system comprises at least one light emitter and at least one light sensor capable of providing at least one collision-preventing light beam.

According to an advantageous embodiment of the invention, the collision-preventing detection system comprises a light beam scanning the surface of the light-sensitive material in a suitable distance from the surface, i.e. 1 mm. This light beam may be emitted from a various number of illumination sources well-known to the skilled person, e.g. a laser. After crossing the relevant surface the light beam is detected by a light sensor, which is able to detect whether the intensity of the light beam drops as a result of the fact that the light beam strikes an obstacle such as a protrusion from the surface.

The beam of light is typically positioned in front of the scanning bar, but between the resin surface and the bottom surface of the scanning bar.

According to a preferred embodiment of the invention, the light sensor and light emitter are both mounted directly on the exposure system. Hereby the sensor and emitter move simultaneously with the scanning bar, whereby a sensing for possible obstacles in an area of the resin surface may be carried out immediately before the exposure system reaches that area of the resin surface.

In an embodiment of the invention, the exposure system comprises one or more light-emitting diodes as illumination sources.

According to an embodiment of the invention more than one light-emitting diode is used to increase the intensity of emitted light. With an increased intensity of light it is possible to increase the scanning speed of the exposure system across the illumination area.

In an embodiment of the invention, light from one specific light-emitting diode is illuminating one specific spatial light modulator.

According to an embodiment of the invention one specific light-emitting diode is then dedicated to one specific spatial light modulator. This may be very advantageous because it then becomes possible to completely turn off one light-emitting diode if patterned light from one of the spatial light modulators does not have to be used to build one layer of an object. Turning off one light-emitting diode reduces the energy consumption as well as the generation of heat.

According to an embodiment of the invention the relationship between the light-emitting diodes and the spatial light modulators is a one to one relationship. This one to one relationship adds a high degree of flexibility e.g. enables the exposure system to turn on or off each individual spatial light modulator.

However, light-emitting diodes arrays can be used as a direct illumination source and their light can be focused directly onto the illumination area without the need of spatial light modulators.

In an embodiment of the invention, said apparatus facilitates that said exposure system is scanned and moved across said light-sensitive material, so as to irradiate the required areas of the curable resin.

In an advantageous embodiment of the invention the exposure system is scanned and moved across a light-sensitive material. The spatial light modulators pattern light to cure an illumination area on the light-sensitive material, when the exposure system is scanned across the light-sensitive material. The exposure head is scanned across the light-sensitive material at least one time per layer of the object to be built and irradiates areas of the curable resin.

### Resin composition

Part of the inventive system is a resin composition according to the claims.

According to the invention, the system comprises a photocurable resin composition comprising :
(A) at least one urethane acrylate or methacrylate component, or any mixture thereof;
(B) at least one monofunctional acrylate, methacrylate, vinylamide, acrylamide or methacrylamide component, preferably with a viscosity below 100 mPa·s at 30°C, or any mixture thereof;
(C) at least one photo initiator, or any mixture thereof.

According to a preferred embodiment of the present invention the urethane acrylate or methacrylate component (A) is an aliphatic polyester diacrylate or dimethacrylate with average molecular weight (MW) between 400 and 10 000 g/mol, preferably between 400 and 3 000 g/mol, and preferably with a polydispersity (PDI) below 1.4, or any mixture thereof.

In particular, the urethane acrylate or methacrylate component (A) may be favourably produced by reacting a polyalkylene, a polyalkylene glycol, preferably a polyethylene glycol, with caprolactone, isophorone diisocyanate and an hydroxyalkylacrylate, preferably hydroxyethylacrylate. The monofunctional component (B) is preferably an acrylamide or methacrylamide or any mixture thereof, for example acryloylmorpholine.

It has been surprisingly found that the combination of (A), (B) and (C) results in a photocurable composition which exhibits high photosensitivity, high curing speed, low shrinkage, high toughness, high tensile strength and modulus and good mechanical properties of the produced 3-D objects, so that such composition is particularly suited to be used in an apparatus characterized by the features as described above.

According to a preferred embodiment of the present invention the resin composition comprises:
(A) 20 - 60 % by weight of the urethane acrylate or methacrylate component A ;
(B) 10 - 70 % by weight of the monofunctional acrylate, methacrylate, vinylamide, acrylamide or methacrylamide component B;
(C) 0.1 - 10 % by weight of the photo initiator C;
(D) 1 - 20 % by weight of at least a tetrafunctional acrylate or methacrylate component, or any mixture thereof;
(E) optionally 0.1 - 50 % by weight of a difunctional acrylate or methacrylate component, or any mixture thereof, preferably a polyethylene glycol diacrylate or an ethoxylated bisphenol dimethacrylate, or tricyclodecane dimethanol diacrylate, or any mixture thereof, based on the total weight of the resin composition.

According to another preferred embodiment of the present invention the resin composition comprises:
(A) 20 - 50 % by weight of the urethane acrylate or methacrylate component A;
(B) 10 - 50 % by weight of the monofunctional acrylate, methacrylate, vinylamide, acrylamide or methacrylamide component B;
(C) 0.5 - 7 % by weight of the photo initiator C;
(D) 1 - 20 % by weight of at least one tetrafunctional acrylate or methacrylate component, or any mixture thereof, preferably ethoxylated pentaerythritol tetraacrylate;
(E) 0.5 - 45 % by weight of a difunctional acrylate or methacrylate component, or any mixture thereof, preferably a polyethylene glycol diacrylate or an ethoxylated bisphenol dimethacrylate, or a tricyclodecane dimethanol diacrylate, or any mixture thereof, based on the total weight of the resin composition.

According to a preferred embodiment of the present invention, the resin composition of the system comprises additionally 0.1 to 20 % by weight of core shell nanoparticles (F), based on the total weight of the resin composition, preferably 1 to 10 % by weight. Core shell nanoparticles are filler particles with size from 0.01 to 100 µm, more preferably from 0.01 to 10 µm, and exhibiting an elastic core and a reactive shell. The addition of core shell nanoparticles, for example comprising silica, to the resin composition surprisingly increases dramatically the toughness of the produced objects and reduces drastically the crack propagation.

According to a preferred embodiment of the present invention, the resin composition of the system comprises additionally 0.1 to 3 % by weight of an oxygen scavenger, preferably triphenylphosphite.

According to a preferred embodiment of the present invention, the resin composition of the system comprises additionally 0.001 to 1 % by weight of flow and wetting additives, preferably at least two of them.

Another object of the present invention relates to a photocurable resin composition comprising:
(A) at least one aliphatic polyester urethane acrylate or methacrylate component with average molecular weight (MW) between 400 and 10 000 g/mol, preferably between 400 and 3 000 g/mol, and preferably with a polydispersity (PDI) below 1.4, or any mixture thereof;
(B) at least one monofunctional acrylate, methacrylate, vinylamide, acrylamide or methacrylamide component, preferably with a viscosity below 100 mPa·s at 30°C, or any mixture thereof;
(C) at least one photo initiator, or any mixture thereof.

It has been surprisingly found that the combination of (A), (B) and (C) results in a photocurable composition which exhibits high photosensitivity, high curing speed, low shrinkage, high toughness, high tensile modulus and strength and good mechanical properties of the produced 3-D objects, so that such composition is particularly suited to be used in an apparatus characterized by the features as described above.

The urethane acrylate or methacrylate component (A) is produced favourably by reacting a polyalkylene glycol, preferably a polyethylene glycol, with caprolactone, isophorone diisocyanate and an hydroxyalkylacrylate, preferably hydroxyethylacrylate. The monofunctional component (B) is preferably an acrylamide or methacrylamide or any mixture thereof, for example acryloylmorpholine.

In particular, the resin composition comprises preferably at least:
(A) 20 - 60 % by weight of the urethane acrylate or methacrylate component A;
(B) 10 - 70 % by weight of the monofunctional acrylate, methacrylate, vinylamide, acrylamide or methacrylamide component component B;
(C) 0.1 - 10 % by weight of the photo initiator C;
(D) 1 - 20 % by weight of a tetrafunctional acrylate or methacrylate component, or any mixture thereof;
(E) optionally 0.1 - 50 % by weight of a difunctional acrylate or methacrylate component, or any mixture thereof, preferably a polyethylene glycol diacrylate or an ethoxylated bisphenol dimethacrylate, or a tricyclodecane dimethanol diacrylate, or any mixture thereof,
   based on the total weight of the composition.

In a preferred embodiment the resin composition comprises at least:
(A) 20 - 50 % by weight of the urethane acrylate or methacrylate component A;
(B) 10 - 50 % by weight of the monofunctional acrylate, methacrylate, vinylamide, acrylamide or methacrylamide component component B;
(C) 0.5 - 7 % by weight of the photo initiator C;
(D) 1 - 20 % by weight of a tetrafunctional acrylate or methacrylate component, or any mixture thereof, preferably ethoxylated pentaerythritol tetraacrylate;
(E) 0.5 - 45 % by weight of a difunctional acrylate or methacrylate component, or any mixture thereof, preferably a polyethylene glycol diacrylate or an ethoxylated bisphenol dimethacrylate, or a tricyclodecane dimethanol diacrylate, or any mixture thereof,
   based on the total weight of the resin composition.

According to a preferred embodiment of the present invention, the resin composition comprises additionally 0.1 to 20 % by weight, preferably 1 to 10 % by weight , of core shell nanoparticles (F), based on the total weight of the resin composition. The addition of core shell nanoparticles, for example comprising silica, to the resin composition surprisingly increases dramatically the toughness of the produced objects and reduces drastically the crack propagation.

According to a preferred embodiment of the present invention, the resin composition comprises additionally 0.1 to 3 % by weight of an oxygen scavenger, preferably triphenylphosphite.

According to a preferred embodiment of the present invention, the resin composition comprises additionally 0.001 to 1 % by weight of flow and wetting additives, preferably at least two of them.

### (A) Urethane acrylate or methacrylate component

In the following paragraph, suitable urethane acrylate or methacrylate components for resin compositions according to the present invention are listed. A urethane acrylate or methacrylate component may refer to a single urethane acrylate or methacrylate compound or to a mixture of different urethane acrylate or methacrylate compounds. Suitable urethane acrylate or methacrylate components can be monofunctional, but preferably are difunctional or of higher functionality. The functionality refers to the number of acrylate or methacrylate functional groups exhibited by the molecule of the compound.

Urethane acrylates may be prepared by reacting an hydroxyl-terminated polyurethane with acrylic acid, or by reacting an isocyanate-terminated prepolymer with hydroxyalkyl acrylates to give the urethane acrylate. Preferred are urethane acrylates made from polyester diols, caprolactone, aliphatic or cyclic isocyanates and hydroxyalkyl acrylates. Also preferred are those having polyfunctionality of acrylates or mixed acrylic and methacrylic functionality. The urethane acrylate or methacrylate component (A) can be in particular produced by reacting a polyalkylene glycol, preferably a polyethylene glycol, with caprolactone, isophorone diisocyanate and an hydroxyalkylacrylate, preferably hyd roxyethylacrylate.

Urethane methacrylates may be prepared also by reacting an hydroxyl-terminated polyurethane with methacrylic acid, or by reacting an isocyanate-terminated prepolymer with hydroxyalkyl methacrylates to give the urethane methacrylate. Preferred are urethane methacrylates made from polyester diols, caprolactone, aliphatic or cyclic isocyanates and hydroxyalkyl methacrylates. Also preferred are those having polyfunctionality of methacrylates or mixed acrylic and methacrylic functionality.

Examples of preferred aliphatic urethane acrylates used in resins according to the invention include CN981^{®}, CN9007^{®}, CN9290US^{®}, CN9788^{®}, CN9009^{®}, CN9001^{®}, CN9011^{®}, CN962^{®}, CN964^{®}, CN965^{®}, CN991^{®}, CN983^{®}, CN984^{®} (from Sartomer), EBECRYL 1259, 1290, 4820, , 8402, 8405, 8800, 9260 (from Cytec), Genomer 4215, 4217, 4425, 4590 (from Rahn), BR-441, BR-441PM, BR-446, BR-741, BR-571, BR-970 (from Bomar), EC6112-100, EC6132, EC6144-100 (from IGM ).

Most preferably the aliphatic urethane acrylates are CN981, or other polyester aliphatic urethane diacrylates like CN9007^{®}, CN9290US^{®}, CN9788^{®}, CN9009^{®}, CN9001^{®}, CN9011^{®}, CN962^{®}, CN964^{®}, CN965^{®}, CN991^{®}, CN983^{®}, CN984^{®} (from Sartomer).

Ebecryl^{®} 270 or other polyether aliphatic urethane diacrylates may be used as well.

### (B) Monofunctional acrylate, methacrylate, vinylamide, acrylamide or methacrylamide component

In the following paragraph, suitable monofunctional acrylate, methacrylate, vinylamide, acrylamide or methacrylamide components for resin compositions according to the present invention are listed. The component may refer to a single compound or to a mixture of different compounds and has the function of reactive diluent. Monofunctional refers to the fact that the molecule of the compound exhibits only one acrylate, methacrylate, vinylamide, acrylamide or methacrylamide functional group.

Examples of monofunctional acrylamide or methacrylamide components include such as acryloylmorpholine, N-(hydroxymethyl)acrylamide, N-Hydroxyethyl acrylamide, N-Isopropylacrylamide, N-Isopropylmethacrylamide, N-tert-Butylacrylamide, N,N'-Methylenebisacrylamide, N-(Isobutoxymethyl)acrylamide, N-(Butoxymethyl)acrylamide, N-[3-(Dimethylamino)propyl]methacrylamide, N,N-Dimethylacrylamide, N,N-Diethylacrylamide, N-(hydroxymethyl)methacrylamide, N-Hydroxyethyl methacrylamide, N-Isopropylmethacrylamide, N-Isopropylmethmethacrylamide, N-tert-Butylmethacrylamide, N,N'-Methylenebismethacrylamide, N-(Isobutoxymethyl)methacrylamide, N-(Butoxymethyl)methacrylamide, N-[3-(Dimethylamino)propyl]methmethacrylamide, N,N-Dimethylmethacrylamide, N,N-Diethylmethacrylamide.

Examples of monofunctional vinylamide components include such as N-vinyl-pirrolidone, vinyl-imidazole, N-vinylcaprolactame, N-(hydroxymethyl)vinylamide, N-Hydroxyethyl vinylamide, N-Isopropylvinylamide, N-Isopropylmethvinylamide, N-tert-Butylvinylamide, N,N'-Methylenebisvinylamide, N-(Isobutoxymethyl)vinylamide, N-(Butoxymethyl)vinylamide, N-[3-(Dimethylamino)propyl]methvinylamide, N,N-Dimethylvinylamide, N,N-Diethylvinylamide,
N-Methyl-N-vinylacetamide.

Examples of monofunctional acrylates include such as isobornyl acrylate, tetrahydrofurfuryl acrylate, ethoxylated phenyl acrylates, lauryl acrylate, stearyl acrylate, octyl acrylate, isodecyl acrylate, tridecyl acrylate, caprolactone acrylate, nonyl phenol acrylate, cyclic trmethylolpropane formal acrylate, methoxy polyethyleneglycol acrylates, methoxy polypropyleneglycol acrylates, hydroxyethyl acrylate, hydroxypropyl acrylate, glycidyl acrylate. This list is not exhaustive and in each case ethoxylation and / or propoxylation of those acrylates can be used to modify properties further.

Examples of monofunctional methacrylate include isobornyl methacrylate, tetrahydrofurfuryl methacrylate, ethoxylated phenyl methacrylate, cyclohexylmethacrylate, lauryl methacrylate, stearyl methacrylate, octyl methacrylate, isodecyl methacrylate, tridecyl methacrylate, caprolactone methacrylate, nonyl phenol methacrylate, cyclic trmethylolpropane formal methacrylate, methoxy polyethyleneglycol methacrylates, methoxy polypropyleneglycol methacrylates, hydroxyethyl methacrylate, hydroxypropyl methacrylate, glycidyl methacrylate. This list is not exhaustive and in each case ethoxylation and / or propoxylation of those methacrylates can be used to modify properties further.

### (C) Photoinitiators

According to the present invention, the resin composition comprises at least a photo initiator. The photo initiator can be a photo initiating system comprising a combination of different photo initiators and/or sensitizers. The photo initiating system can, however, be also a system comprising a combination of different compounds, which do not exhibit any photo initiating property when taken alone, but which do exhibit photo initiating properties when combined together.

The photo initiator may be chosen from those commonly used to initiate radical photo polymerization.

Examples of free radical photo initiators include benzoins, e.g., benzoin, benzoin ethers such as benzoin methyl ether, benzoin ethyl ether, benzoin isopropyl ether, benzoin phenyl ether, and benzoin acetate; acetophenones, e.g., acetophenone, 2,2-dimethoxyacetophenone, and 1,1-dichloroacetophenone; benzil ketals, e.g., benzil dimethylketal and benzil diethyl ketal; anthraquinones, e.g., 2-methylanthraquinone, 2-ethylanthraquinone, 2-tertbutylanthraquinone, 1-chloro-anthraquinone and 2-amylanthraquinone; triphenylphosphine; benzoylphosphine oxides, e.g., 2,4,6-trimethylbenzoyl-diphenylphosphine oxide (Lucirin ® TPO); bisacylphosphine oxides; benzophenones, e.g., benzophenone and 4,4'-bis(N,N'-di-methylamino)benzophenone; thioxanthones and xanthones; acridine derivatives; phenazine derivatives; quinoxaline derivatives; 1-phenyl-1,2-propanedione 2-O-benzoyl oxime; 4-(2-hydroxyethoxy)phenyl-(2-propyl)ketone (Irgacure 2959; Ciba Specialty Chemicals); 1-aminophenyl ketones or 1-hydroxy phenyl ketones, e.g., 1-hydroxycyclohexyl phenyl ketone, 2-hydroxyisopropyl phenyl ketone, phenyl 1-hydroxyisopropyl ketone, and 4-isopropylphenyl
1-hydroxyisopropyl ketone. Irgacure® 369 can also be used.

For this application, the radical photo initiators are preferably selected and their concentrations are preferably adjusted to achieve an absorption capacity such that the depth of cure is from about 0.05 to about 2.5 mm.

### (D) Tetrafunctional acrylate or methacrylate component

According to a preferred embodiment of the invention, the photocurable composition comprises a tetrafunctional acrylate or methacrylate. The component may refer to a single compound or to a mixture of different compounds. Tetrafunctional refers to the fact that the molecule of the compound exhibits four acrylate or methacrylate functional groups.

Examples are bistrimethylolpropane tetraacrylate, pentaerythritol tetracrylate (Sartomer ® 295), tetramethylolmethane tetramethacrylate (Sartomer ® 367), pentaerythritol tetramethacrylate, bistrimethylolpropane tetramethacrylate, ethoxylated pentaerythritol tetraacrylate (Sartomer ® 494), propoxylated pentaerythritol tetraacrylate, dipentaerythritol tetraacrylate, ethoxylated dipentaerythritol tetraacrylate, propoxylated dipentaerythritol tetraacrylate, aryl urethane tetraacrylates, aliphatic urethane tetraacrylates, melamine tetraacrylates, epoxy novolac tetraacrylates, polyester tetraacrylates and mixtures thereof.

This list is not exhaustive and in each case ethoxylation and / or propoxylation of those tetra(meth)acrylates can be used to modify properties further.

### (E) Difunctional acrylate or methacrylate component

According to a preferred embodiment of the invention, the photocurable composition comprises a difunctional (meth)acrylate. The component may refer to a single compound or to a mixture of different compounds. Difunctional refers to the fact that the molecule of the compound exhibits two acrylate or methacrylate functional groups.

Examples of preferred aliphatic or cycloaliphatic diacrylates include tricyclodecane dimethanol diacrylate (Sartomer ® 833s), dioxane glycerol diacrylate (Sartomer ® CD 536), 1,6 hexanediol diacrylate (Sartomer ® 238), 3-methyl 1, 5-pentanediol diacrylate (Sartomer ® 341), tripropylene glycol diacrylate (Sartomer® 306), Neopentyl glycol diacrylate (Sartomer® 247), dimethyloltricyclodecane diacrylate (Kayarad R-684), 1,4-dihydroxymethylcyclohexane diacrylate, 2,2-bis(4-hydroxy-cyclohexyl)propane diacrylate, bis(4-hydroxycyclohexyl)methane diacrylate. Examples of acyclic aliphatic diacrylates include compounds of the formulae (F-I) to (F-IV) of U.S. Patent No. 6,413,697, herein incorporated by reference. Further examples of possible diacrylates are compounds of the formulae (F-V) to (F-VIII) of U.S. Patent No. 6,413,697. Their preparation is also described in EP-A-0 646 580, herein incorporated by reference. Some compounds of the formulae (F-I) to (F-VIII) are commercially available. This list is not exhaustive and in each case ethoxylation and / or propoxylation of those diacrylates can be used to modify properties further.

Examples of aromatic diacrylates include bisphenol A polyethylene glycol diether diacrylate (Kayarad R-551), 2,2'-methylenebis[p-phenylenepoly(oxyethylene)oxy]-diethyl diacrylate (Kayarad R-712), hydroquinone diacrylate, 4,4'-dihydroxybiphenyl diacrylate, Bisphenol A diacrylate, Bisphenol F diacrylate, Bisphenol S diacrylate, ethoxylated or propoxylated Bisphenol A diacrylate, ethoxylated or propoxylated Bisphenol F diacrylate, ethoxylated or propoxylated Bisphenol S diacrylate, bisphenol-A epoxy diacrylate (Ebecryl ® 3700 UCB Surface Specialties).

Examples of preferred polyethylenglycol diacrylates used in resins according to the invention are tetraethyleneglycol diacrylate (Sartomer ® 268), polyethyleneglycol(200) diacrylate (Sartomer ® 259), polyethyleneglycol(400) diacrylate (Sartomer ® 344). This list is not exhaustive and in each case ethoxylation and / or propoxylation of those diacrylates can be used to modify properties further.

According to a preferred embodiment of the invention, the photocurable composition comprises difunctional methacrylates.

Examples of preferred aromatic dimethacrylates used in resins according to the invention include ethoxylated (2) bisphenol A dimethacrylate (Sartomer ® 101 K), ethoxylated (2) bisphenol A dimethacrylate (Sartomer ® 348L), ethoxylated (3) bisphenol A dimethacrylate (Sartomer ® 348C), ethoxylated (4) bisphenol A dimethacrylate (Sartomer ® 150), ethoxylated (4) bisphenol A dimethacrylate (Sartomer ® 540), ethoxylated (10) bisphenol A dimethacrylate (Sartomer ® 480), hydroquinone dimethacrylate, 4,4'-dihydroxybiphenyl dimethacrylate, Bisphenol A dimethacrylate, Bisphenol F dimethacrylate, Bisphenol S dimethacrylate, ethoxylated or propoxylated Bisphenol A dimethacrylate, ethoxylated or propoxylated Bisphenol F dimethacrylate, and ethoxylated or propoxylated Bisphenol S dimethacrylate.

Examples of aliphatic or cycloaliphatic dimethacrylates include 1,4-dihydroxymethylcyclohexane dimethacrylate, 2,2-bis(4-hydroxy-cyclohexyl)propane dimethacrylate, bis(4-hydroxycyclohexyl)methane,

Examples of acyclic aliphatic dimethacrylates include compounds of the formulae (F-I) to (F-IV) of U.S. Patent No. 6,413,697, herein incorporated by reference. Further examples of possible dimethacrylates are compounds of the formulae (F-V) to (F-VIII) of U.S. Patent No. 6,413,697. Their preparation is also described in EP-A-0 646 580, herein incorporated by reference. Some compounds of the formulae (F-I) to (F-VIII) are commercially available. This list is not exhaustive and in each case ethoxylation and / or propoxylation of those dimethacrylates can be used to modify properties further.

### (F) Filler

According to a preferred embodiment of the present invention, the resin composition may comprise a filler, for example core shell nanoparticles. Core shell nanoparticles can be particles with a core made of a silicone elastomer, having an organic shell structure comprising reactive groups, with a defined size from 0.01 to 100 µm, more preferably from 0.01 to 10 µm.

A preferred filler is Albidur XP1/0767, which comprises 40 wt% silica nanoparticles in 60 wt% alkoxylated pentaerythritol tetraacrylate.

Other possible fillers are nanoalumina (Nanobyk 3600, 3601, 3602) or nanosilica particles (Nanocryl, Nanoresins), Albidur® EP 2240 , Albidur® EP 2240 A, Albidur® EP 5340, Albidur® PU 5640, Albidur® UP 6140, Albidur® VE 3320 .

### Figures

Specific inventive embodiments and examples of the apparatus of the system according to the present invention will now be described more in detail with reference to the figures of which
fig. 1 illustrates a simplified cross-sectional view of a stereo lithography apparatus,
fig. 2 illustrates a part of the exposure system according to an embodiment of the invention,
fig. 3 illustrates a cross-sectional view of part of a stereo lithography apparatus comprising a collision-preventing detection system according to an embodiment of the invention,
fig. 4 corresponds to fig. 3 rotated 90°,
fig. 5 illustrates a collision-preventing detection system according to an embodiment of the invention,
fig. 6 illustrates a protective window according to an embodiment of the invention,
fig. 7 illustrates a replaceable module comprising a protective window according to an embodiment of the invention,
fig. 8 illustrates a cross-sectional view of part of a stereo lithography apparatus comprising a replaceable module according to an embodiment of the invention,
fig. 9 illustrates an example of a stereo lithography apparatus according to an embodiment of the invention in a front / side view,
fig. 10 illustrates an example of a stereo lithography apparatus according to an embodiment of the invention in a back / side view,
fig. 11 illustrates an example of a stereo lithography apparatus according to an embodiment of the invention in a front view,
fig. 12 illustrates a H-Bench measurement apparatus for differential shrinkage, and the dimensions of the H-bench.

### Embodiments and examples

### System

Examples of a method and an illumination unit for point illumination of a medium explaining how to collimate light and illuminate suitable to embodiments of the present invention can be seen e.g. in WO 98/47048, hereby incorporated by reference.

Examples of an illumination unit and a method of point illumination of a medium comprising a plurality of light emitters in the form of light guides which are arranged to illuminate at least one illumination face via a light valve arrangement suitable to embodiments of the present invention can be found e.g. in WO 98/47042, hereby incorporated by reference.

An example of a rapid prototyping apparatus for the manufacturing of three-dimensional objects by additive treatment of cross-sections comprising a wholly or partially light-sensitive material is described in WO 00/21735, hereby incorporated by reference. This apparatus comprises at least one light source for illumination of a cross-section of the light-sensitive material by at least one spatial light modulator of individually controllable light modulators, wherein at least one light source is optically coupled with a plurality of light guides arranged with respect to the spatial light modulator arrangement in such a manner that each light guide illuminates a sub-area of the cross-section.

Within the context of this description and the appended claims, with the term "illumination area" is meant an approximated plane as defined by a number of focus points of the individual light beams originating from the output optics.

Within the context of this description and the appended claims, with the term micro-lenses is meant small lenses, generally with diameters less than one millimetre (mm).

Within the context of this description and the appended claims, with the term focusing distance d is meant the minimum distance from the output optics to the illumination area.

Within the context of this description and the appended claims, with the term light-sensitive material is meant a material sensitive to light and suitable for three-dimensional rapid prototyping. Such material will be well-known to the skilled person and could advantageously be different kinds of resin; hence the term resin, resin composition and the term light-sensitive material are used interchangeably herein.

Within the context of this description and the appended claims, with the term Illumination Area is meant the cross-sectional area of the light beam at the distance, where the light beam is best focused.

Within the context of this description and the appended claims, a pattern of light can be caused by any combination of the light modulators, e.g. when all light modulators are open, a single line of light modulators are open, some individual light modulators are open or any other combination of settings of the light modulators.

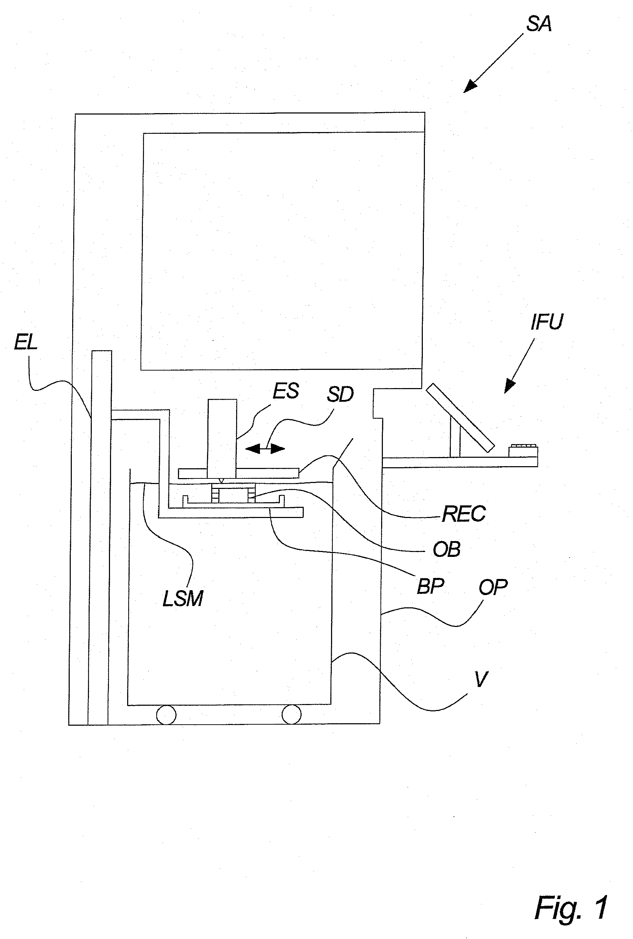

Figure 1 illustrates a simplified cross-sectional view of a stereo lithography apparatus SA for building three-dimensional objects OB according to one aspect of the present invention. The three-dimensional objects OB are built layer-wise through the curing of light sensitive material LSM when exposed to light from the exposure system ES.

The stereo lithography apparatus SA comprises a building plate BP, on which one or more three-dimensional objects OB is built. The building plate BP is moved vertically into a vat V comprising light-sensitive material LSM by means of an elevator EL. A recoater REC is according to an aspect of the invention scanned across the new layer of light-sensitive material LSM to ensure uniformity of the new layer. The scanning direction SD of the exposure system ES is indicated with arrows.

According to the above description the three-dimensional object OB is built by exposing a layer of light-sensitive material LSM with patterned light from the exposure system ES. The part of the light-sensitive material LSM is cured according to the pattern of light to which it is exposed. When a first layer is cured, the building plate BP with the cured first layer of the three dimensional object OB is lowered into the vat V and the recoater REC scans across the layer of light-sensitive material LSM in order to establish a fresh upper layer of light-sensitive material LSM. Then the exposure system ES is again scanned across the light-sensitive material LSM curing a new layer of the three-dimensional object OB.

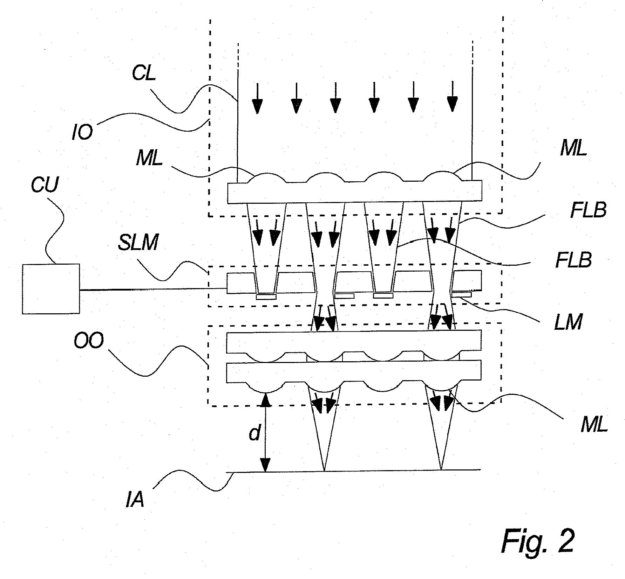

As mentioned, the stereo lithography apparatus SA comprises an exposure system ES. The exposure system ES comprises an incoherent illumination source, which may be a UV-lamp, a diode, a number of diodes, or any other means of illumination source known by the skilled person suitable for the purpose of curing the light-sensitive material. Following the illumination source there are means for transforming the light from the illumination source into collimated light together with input optics IO, spatial light modulators SLM, and output optics OO. The part of the exposure system following the means of collimating the light is depicted on fig. 2.

At least part of the exposure system ES is scanned across the light-sensitive material LSM in a scanning direction SD, illuminating an illumination area IA on the surface of the light-sensitive material LSM according to a digital layer-wise representation of the three-dimensional object OB. According to an aspect of the invention, the exposure system ES is curing the light-sensitive material LSM in the illumination area IA, thereby forming the three-dimensional object OB.

In an aspect of the invention, the vat V may be equipped with means for moving the vat V such as wheels, interactions with a rail, track, forklifts etc. Hence the vat V may be removable located in the stereo lithography apparatus SA e.g. accessible via an opening OP to refill the vat V with light-sensitive material LSM or to easy removal of three-dimensional objects OB from the building plate BP.

It should be noted that it is possible, e.g. by means of the illustrated elevator EL or other devices, to move the vat V vertically instead of moving the building plate BP.

The digital layer-wise representation of the three-dimensional object OB may, according to an aspect of the invention, be provided to the stereo lithography apparatus SA via an interface unit IFU. The interface unit IFU may comprise input interfaces, such as e.g. a keyboard or pointer and output interfaces such as e.g. a screen or a printer, to handle communication via interfaces such as e.g. LAN (LAN; Local Area Network), WLAN (WLAN; Wireless Local Area Network), serial communication etc. Furthermore the interface unit IFU may comprise data processors, memory's and/or means for permanent storing of data.

Figure 2 illustrates a simplified cross-sectional view of the part of the exposure system following the means of collimating the light according to an aspect of the invention.

According to one aspect of the invention, in order to transmit light from the illumination source to at least part of the light modulators LM of the at least one spatial light modulator SLM, light guides are used between the means for collimation and the input optics IO. In another aspect of the invention, which may be combined with the other, light guides are used between the illumination source and the means for collimation. Such light guides may e.g. comprise optical fibres (e.g. made of polymer, plastic, glass etc.), optics, lens arrays, reflectors, etc.

According to an aspect of the invention the light-sensitive material LSM may be a determining factor for the choice of illumination source. Typically the light-sensitive material LSM is cured when exposed or illuminated with light of high intensity within wavelengths between 200-500 nm. Typically light with a wavelength peaks between 300 and 400 nm are the most optimal for curing the preferred type of light-sensitive material LSM. Of course, light with other than the mentioned wavelengths may be used if a special light-sensitive material LSM is required. Since the illumination source is incoherent, the light is emitted with a broad wavelength range and several chemical compounds and photo initiators can be activated in the light-sensitive material.

It should be noted that the light-sensitive material LSM is also cured when it is exposed to a broad-spectrum light e.g. from the diffuse illumination distribution of a room, because the diffuse illumination distribution of a room often also contains light with wavelengths on which the light-sensitive material LSM reacts. Curing of light-sensitive material LSM from such stray light is not desirable because it is slow and not controllable.

The intensity of the light emitted from the illumination source may according to an aspect of the invention vary. The higher the intensity, the shorter the time the light-sensitive material LSM has to be exposed to the light to cure. Hereby the speed of the exposure system ES scanning over the light-sensitive material LSM may be faster. Of course other factors are also determining for the scanning speed such as the type of light-sensitive material LSM, response time in the spatial light modulators SLM, etc.

According to an aspect of the invention, the exposure system comprises input optics IO, at least one spatial light modulator SLM and output optics OO. Hence light from the illumination source are, by means of the input optics IO, at least partly collimated and focused onto at least some of the apertures of the at least one spatial light modulator SLM. The at least one spatial light modulator SLM then establishes a pattern of light onto the output optics OO, which again focuses the patterned light on the illumination area IA on the light-sensitive material LSM.

It should be noted that a pattern of light also includes the situation when all individual light modulators LM of the spatial light modulator SLM are in a position which either lets light through all apertures of the spatial light modulator SLM or does not let any light at all through the apertures of the spatial light modulator SLM.

According to a preferred aspect of the invention the stereo lithography apparatus SA comprises more than 48 spatial light modulators SLM. It should be noted that the stereo lithography apparatus SA may be very flexible in relation to the number of spatial light modulators SLM. Hence the number of spatial light modulators SLM may vary between 1 and e.g. up to more than 100.

According to an aspect of the invention, the individual spatial light modulators SLM may be combined in modules of four. Hence, according to a preferred aspect of the invention, when more than four spatial light modulators SLM are needed, more than one module are combined together forming the exposure system ES.

Each spatial light modulator SLM comprises according to an aspect of the invention more than 500 individually controllable light modulators LM. Of course, spatial light modulators SLM with a number which differs from the 500 individually controllable light modulators LM may be used. To simplify the figures, throughout this description the figures only illustrate the spatial light modulators SLM with e.g. four light modulators even though, as mentioned, there may be more than 500.

The input optics IO may according to an aspect of the invention and as shown in fig. 2 comprise a micro lens array. In further embodiments further micro lenses may be included in the input optics as well as other optical elements.

A purpose of the input optics is to focus the collimated light CL onto the at least one spatial light modulator SLM. As explained below, the at least one spatial light modulator SLM comprises a plurality of apertures and it is onto or down through these apertures that the micro lenses ML are focusing the collimated light CL.

The at least one spatial light modulator SLM may according to an aspect of the invention be used to pattern the collimated and focused light onto illumination areas IA on the light sensitive material LSM. The at least one spatial light modulator SLM comprises a plurality of individual light modulators LM also referred to as light switches, light valves, micro shutters etc.

According to an aspect of the invention, the individual controllable light modulators LM are controlled by a control unit CU. The control unit CU may control the exposure system ES according to the digital layer-wise representation of the three-dimensional object to be built. The illustrated control unit CU may control the individual controllable light modulators LM of the at least one spatial light modulator SLM and in the case of individual light-emitting diodes LD, these may also be controlled by the control unit CU.

According to an aspect of the invention where light-emitting diodes LD are used, controlling the light-emitting diodes LD means to turn the light-emitting diodes LD off if e.g. only a small part of an object or a small object is to be built, which does not require patterned light from at least one spatial light modulator SLM included in the exposure system ES.

According to an aspect of the invention, the control of the light modulators LM in the at least one spatial light modulators SLM may be done by addressing the light modulators LM according to the pattern. The pattern may represent one layer of the three dimensional object to be built.

In an embodiment of the invention, the illustrated control unit CU may also control other parts of the stereo lithography apparatus SA than the exposure system ES. Alternatively, the control unit CU may be included in other control systems in relation to the stereo lithography apparatus SA.

According to an aspect of the invention the stereo lithography apparatus SA may be provided with digital layer-wise descriptions of the three-dimensional object to be built. The layer-wise description of the three-dimensional object may include support structure, if the three-dimensional object requires support during the building process. For each layer of the three-dimensional object, the exposure system ES is scanned across the light-sensitive material LSM and the individual digital layer-wise description of the three-dimensional object determines the pattern of light from the spatial light modulator SLM.

According to an aspect of the invention the output optics OO focuses the patterned light from the spatial light modulator SLM onto one or more illumination areas IA on the surface of the light-sensitive material LSM. Like the input optics IO, the output optics OO may comprise more than one lens system e.g. more than one array of micro lenses ML.

A preferred embodiment of part of an exposure system is shown in fig. 2. Collimated light CL is sent through a first micro lens array as part of the input optics IO, which works to focus the collimated light CL into a number of focused light beams FLB suitable for entering each individual shutter on the light modulators LM.
For each open light modulator LM the light will go through and spread out again after having travelled through the light modulator LM. In this shown embodiment, the output optics OO comprises two micro-lens arrays in immediate continuation of one another to focus the light, whereby desired light spots of a diameter of approximately 100 µm are obtained on a focal plane, the illumination area IA, at a distance d of approximately 2-3 mm.

In the shown embodiment this highly advantageous focusing of the light in the desired distance has been obtained by using the above-mentioned two micro-lens arrays in immediate continuation to one another with suitable parameters, namely a curvature radius of 365 µm and a back focal length of 499 µm. Together with the use of a single micro-lens array in the input optics with a curvature radius of 328.5 µm and a back focal length of 425 µm, this combination has proven to provide a highly advantageous combination of optics in the exposure system. However, further optical elements with values of these parameters in a range around such found values have also shown to provide advantageous results.

In this embodiment the used micro-lenses are part of an array comprising a number of lenses manufactured in one piece. Obviously within the scope of the invention, it would be possible to manufacture and insert individual lenses for each individual shutter, or any number of lenses other than the one shown may be combined together on one micro lens plate.

It should be clear that the embodiment shown in fig. 2 is shown solely as an example and suitable embodiments may be obtained by replacing one or more of the micro-lens arrays.

Back focal length and curvature radius are terms well-known to the skilled person. However for sake of clarity these are defined as follows.

A spherical lens has a centre of curvature located in (x, y, z) either along or decentred from the system local optical axis. The vertex of the lens surface is located on the local optical axis. The distance from the vertex to the centre of curvature is the curvature radius of the lens.
Back focal length (BFL) is the distance from the vertex of the last optical surface of the system to the rear focal point.

According to the present invention contamination of the exposure system may be prevented or at least kept at a minimum level by the use of one or more protective windows.

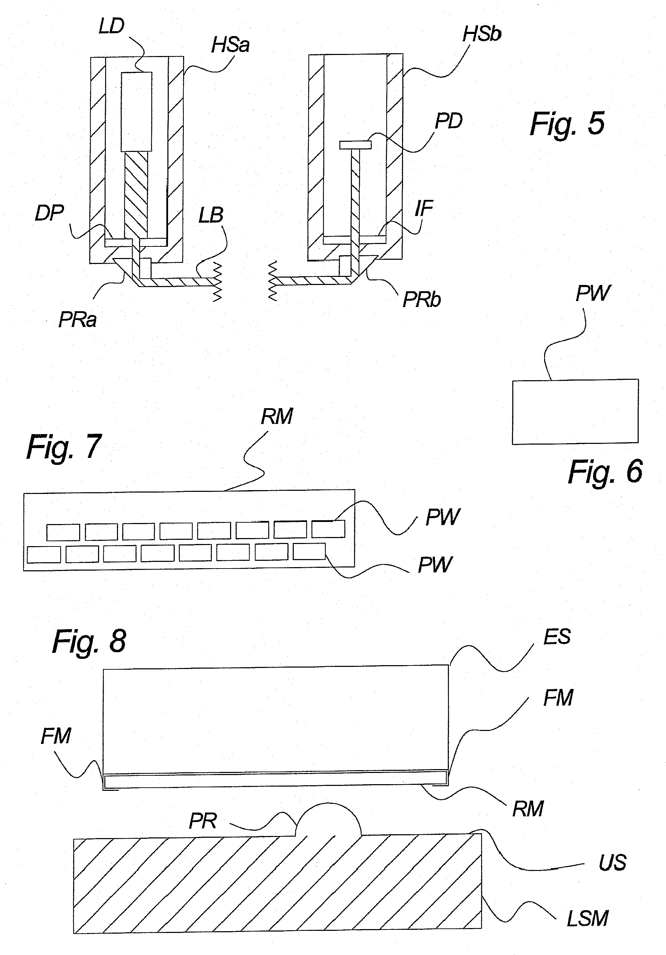

Fig. 6 shows an example of a protective window PW according to an embodiment of the invention.

Fig. 7 shows an example of a replaceable module RM according to an embodiment of the invention. The shown replaceable module RM comprises 16 protective windows PW; however this number may be any other suitable number. In the shown embodiment the individual protective windows PW are mutually displaced to cover the full width of the scanning area. Obviously these protective windows PW may be differently distributed depending on different parameters such as the size of the scanning area etc.

Fig. 8 shows an exposure system ES, on which a replaceable module RM comprising a protective windows PW is mounted in fastening means FM for holding the replaceable module RM. In the shown embodiment these fastening means FM are simply rails on each side of the exposure system ES.
In another advantageous embodiment the fastening means FM is a system where the replaceable module RM can be pushed into a recess and then snapped into a fixed position.
However, a number of different suitable fastening means will be apparent for the skilled person.
A protrusion PR is shown in fig. 8, which in the depicted case may be a bubble in the upper surface US of the resin LSM. Such a bubble is an example of a protrusion PR, which for most resin types will seldom occur. However, if it turns up, this may happen quite suddenly, whereby a possible detection system mounted elsewhere on the apparatus, although effective, might not be sufficient.
With the protective window(s) PW such a bubble may leave small amounts of resin on the protective window(s), but the optics is left undamaged and uncontaminated. Hereby the relatively simple process of replacing the replaceable module RM is sufficient for being able to restart the apparatus following the occurrence of such a bubble.

Another example of a cause of a protrusion is that the curing of the resin may produce a little shrinkage. Such shrinkage may cause that uncured resin LSM surrounding the cured area is pushed up slightly above the level of the surrounding resin. In this way such resin may be brought closer to or even into contact with the exposure system ES.

According to the present invention a sensor may be used to detect obstacles between an exposure system and the resin in additive manufacturing, in order to prevent contamination of the exposure system and to prevent damages on the built part.

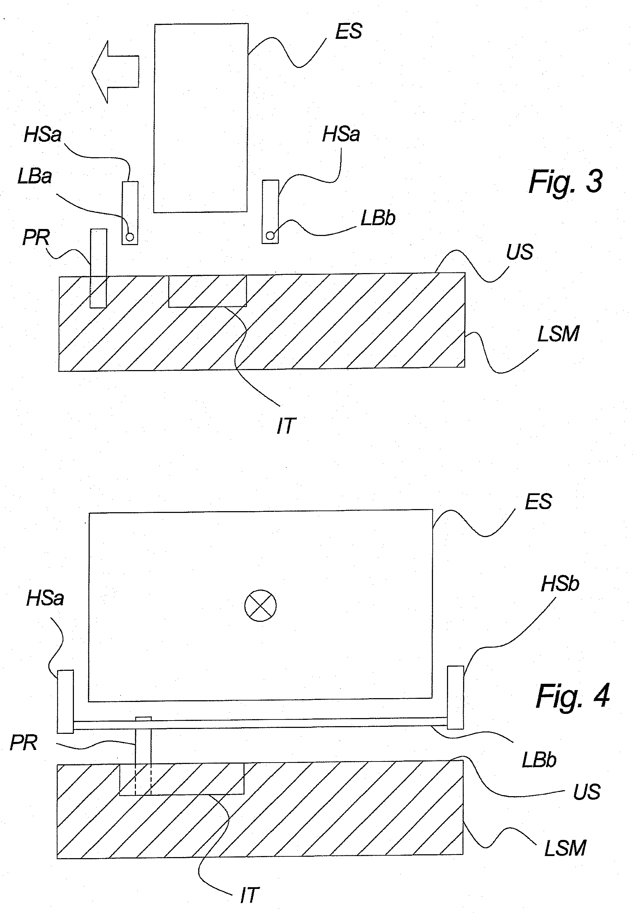

Fig. 3 shows the main parts of the exposure system ES with the exposure system ES moving to the left towards a protrusion PR protruding from the otherwise planar surface of the vat V containing light-sensitive material LSM. In the vat V it is moreover shown a part of an item IT maintaining its upper surface as intended, namely essentially flush with the upper surface US of the light-sensitive material LSM. In the shown embodiment the collision-preventing detection system comprises two laser beams LBa and LBb emitted from housings HSa, which is described more in detail with reference to fig. 5. It is noted that in the shown embodiment two laser beams LBa and LBb are positioned on the sides of the exposure system ES, in order to be able to detect protrusions, no-matter whether the exposure system ES moves to the left or to the right in the shown embodiment. However, in further embodiments of the invention, only one laser beam may be used or even more than two.

Fig. 4 shows the same setting as in fig. 3 in a 90° rotated view, i.e. the exposure system ES moves away from the viewer towards the protrusion PR. Hereby one of the laser beams LBb can be seen extending below the whole width of the exposure system ES from a light-emitting housing HSa to a light-sensing housing HSb. Is it noted that the shown laser beam will be the one to the rear of the moving direction, whereas the one in the front of the moving direction cannot be seen in the figure as it is positioned behind the rear laser beam also drawn in fig. 3.

From the figure it can be seen that the front laser beam LBa, positioned in the figure behind the laser beam LBb, will reach the protrusion PR at some stage during the movement and thereby the laser beam LBa will be interrupted by the protrusion PR resulting in a decreased light intensity reaching the light sensing housing HSb. Hereby it can be concluded that a protrusion PR is present in front of the exposure system ES, which may be a risk for contamination of the exposure system. A signal can be then sent resulting for instance in a stop of the apparatus so that operation staff can solve the problem. In this way the protrusion may be easily removed or lowered and the apparatus may be started again maybe a few minutes later. In case the protrusion PR gets into contact with the exposure system ES a cleaning or replacing process may be necessary resulting in extensive time consumption and costs.

Important elements to make the invention work are the size of the parts in the sensor. As the distance between the bottom surface of the exposure system and the surface of the resin typically is as small as 2 mm, the parts that produce the light beam must be small and made with small tolerances. If the width of the scanning bar as an example is 670 mm, this will also set a lower limit for the distance between emitter and sensor, which will typically be just above this value. Assuming that half the distance between the bottom surface of the exposure system and the resin can be acceptable for the angular misalignment, the angular misalignment must be less than 0.08°. Assuming that half of the distance between the bottom surface of the exposure system and the resin surface can be used for the diameter of the beam, the beam size must be less than 1 mm. Hereby it may be avoided that the receiver will see two sources, one real source from the emitter and one reflection from the resin surface. This illustrates the requirements for the optical parts in the emitter and the sensor and also the requirement to the means used for the micro adjustment of the alignment.

Fig. 5 gives an example of the design of the optical parts, where the two different housings HSa and HSb are shown. Typically the front and the rear set will be the same, hence only one set is shown here.
In this example a laser diode LD emits a laser beam LB which is shaped through a diaphragm DP before it is reflected in a prism PRa through a 90° angle, whereby the beam is directed to be flush just above the surface of the resin. After travelling above the surface US of the resin LSM below the exposure system ES, the beam LB is reflected in a second prism PRb and directed into the light-sensing housing HSb. Before reaching the photo diode PD in this housing, the light beam LB goes through an interference filter IF to avoid that e.g. stray light interferes with the measurement of the photo diode PD.

The use of prisms PRa and PRb is aimed at obtaining a compact design and at avoiding that either the laser diode LD or the photo diode PD need be close to the surface US of the resin LSM. Obviously, angles other than 90° may also be used within the scope of the present invention.

A prism can be used both as an internal or an external reflector; in the embodiment shown in fig. 5 the prisms are used as internal reflectors. An advantage of using prisms as internal reflectors is that the surfaces of the prism can be made flush with the housing and thus give better cleaning possibilities. To protect the fragile edge of the prism, the edge may simply be cut off as shown in fig. 5, which allows for the use of clipped beams, whereby parts of the light beam hitting the part cut off will not be essentially bent; this will not produce any risk of stray light beams from the laser between the emitter and the sensor with a risk of impacting the resin. Hereby, without risk of disturbing stray light, the light beam may be moved as close as possible to the surface of the resin, i.e. to the right in fig. 5. This method may also be used in the external reflection embodiment.

In an advantageous embodiment of the invention the apparatus comprises a restart- button, whereby the apparatus upon an interruption of the laser beam LBa resulting in a stoppage of the apparatus can quickly continue the manufacturing process. This is e.g. advantageous if the interruption was caused by a bubble in the resin or the like, whereby the problem may be solved by the intervention of an operator to the machine.

In an advantageous embodiment of the invention the exposure system comprises modules of spatial light modulators (SLM), wherein each module comprises more than one spatial light modulator.

In an advantageous embodiment of the invention the input optics is made of modules, hence one input optics module corresponds to one module of spatial light modulators.

In an advantageous embodiment of the invention the output optics is made of modules, hence one output optics module corresponds to one module of spatial light modulators. The modular structure of the exposure system, the input optics and the output optics facilitates easy modification of the exposure system e.g. to meet specific user defined requests for the size of the illuminations system.

In an advantageous embodiment of the invention the input and output optics are made of modules, hence one input and one output optic module corresponds to one spatial light modulator.

In an advantageous embodiment of the invention the light modulators of the spatial light modulator pattern the light from the illumination source. The light-sensitive material is cured in a pattern in dependence on the position of the light modulators in the spatial light modulator.

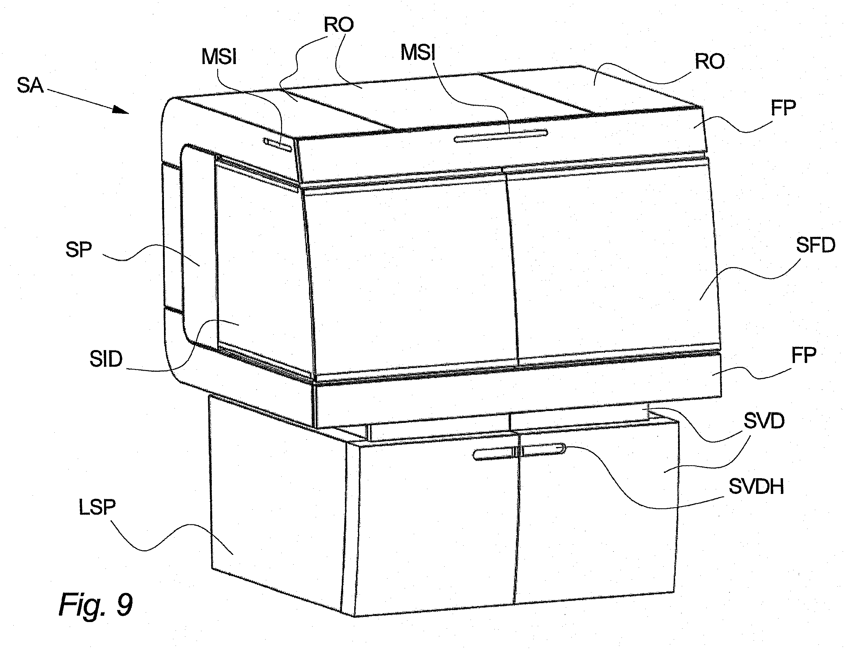

Figure 9-11 illustrates only one possible embodiment of the stereo lithography apparatus SA. It should be noted that not all below mentioned features are necessary for the stereo lithography apparatus SA to operate. Furthermore, it should be noted that not all details of the stereo lithography apparatus SA are illustrated and that additional, not illustrated, parts may be advantageous.

Figure 9 illustrates the stereo lithography apparatus SA in a front / side view according to an aspect of the invention.

The stereo lithography apparatus SA may be equipped with one or more sliding vat doors SVD, which may e.g. be opened by means of a sliding vat door handle SVDH, which is operated e.g. by pushing, turning, etc.. The sliding vat door SVD may give access to the vat V (not shown) by means of sliding to one side or by means of pivoting around one or more hinges.

One or more sliding front doors SFD may be positioned in relation to one or more front panels FP and side panels SP.
The sliding front door SFD may give access to the exposure system ES (not shown) by means of sliding to one side or by means of pivoting around one or more hinges. It should be noted that the sliding front doors SFD may be transparent so that the building process can be monitored without opening the sliding front door SFD.

The one or more front panels FP may extend to the side of the stereo lithography apparatus SA. The one or more front panels FP may be equipped with one or more machine status indicators MSI, indicating the status (e.g. in operation, stopped, fault, etc.) of the machine or at which stage of a building process the stereo lithography apparatus SA is at a given time. The machine status indicator MSI may also be located on the roof RO or side of the stereo lithography apparatus SA and it may e.g. comprise a display, lamps, sirens etc.

Furthermore the stereo lithography apparatus SA may be equipped with one or more side doors SID and one or more lower side panel LSP, which are not in use under normal operation of the stereo lithography apparatus SA. The side doors SID and the lower side panel LSP are only dismounted or opened when parts of the stereo lithography apparatus SA must be maintained.

It should be noted that the side doors SID may according to an aspect of the invention be part of the sliding front door SFD and the lower side panel LSP may according to an aspect of the invention be part of the sliding vat door SVD.

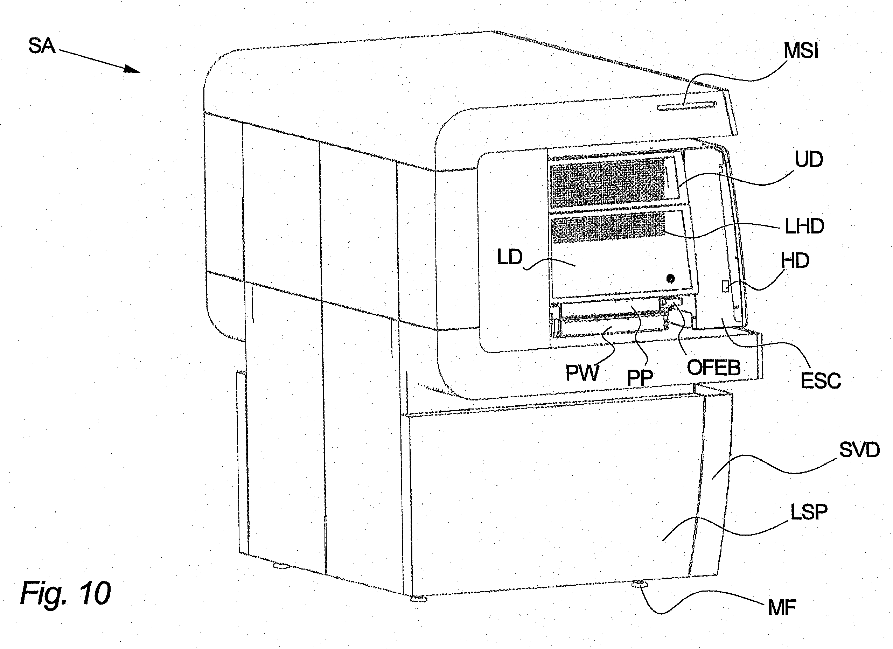

Figure 10 illustrates the stereo lithography apparatus SA in a back / side view according to an aspect of the invention, where the side door SID and the sliding front door SFD are dismounted, revealing the exposure system ES.

The stereo lithography apparatus SA may according to an aspect of the invention stand on one or more machine feet MF, which may be adjustable. This may make easier installing the stereo lithography apparatus SA, so that when the vat V (not shown) is located into the stereo lithography apparatus SA the surface of the light-sensitive material LSM and the output optics OP (not shown) are substantially parallel.

The illustrated exposure system ES comprises an upper left side door UD and a lower left side door LD used when maintaining or servicing the exposure system ES. Furthermore, the exposure system comprises a lamp housing door LHD for accessing the illumination source IS (not shown). Furthermore, the exposure system ES comprises a protection plate PP for protecting the different parts of the illumination unit IU (not shown). The side of the protection window PW is also illustrated on figure 10 together with the outer frame of the exposure bar OFEB

A handle HD for releasing the protection window PW (not shown) may be located in the exposure system casing ESC.

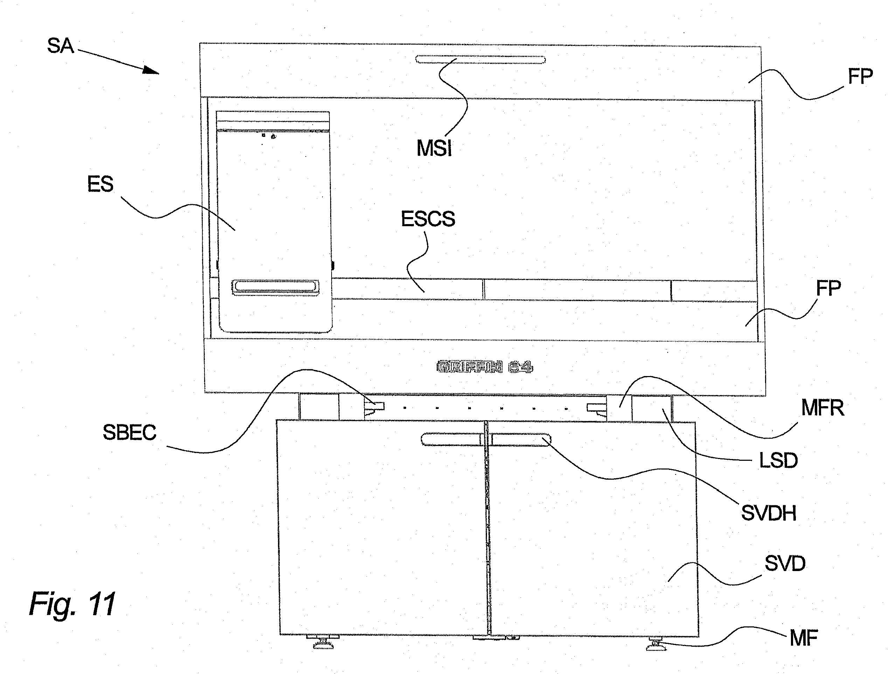

Figure 11 illustrates the stereo lithography apparatus SA in a front view according to an aspect of the invention, where the sliding front door SFD is removed. The exposure system ES is moving in a exposure system carriage slit ESCS, when scanning across the light-sensitive material LSM (not shown). Furthermore figure 11 illustrates the machine frame MFR around which the machine is build and a support base for the exposure system energy chain SBEC.

In the stereo lithography apparatus SA described above the light-sensitive material LSM is illuminated by a low intensity incoherent collimated light CL focused into a number of focused light beams FLB suitable for entering each individual shutter on the light modulators LM. Desired light spots of a diameter of approximately 100 µm are obtained on a focal plane, the illumination area IA, where the upper surface US of the light-sensitive material LSM is situated.

Acrylate or methacrylate based photocurable resin compositions must be therefore used as the light-sensitive material in the system, since acrylate or methacrylate compounds can be cured even by low intensity incoherent light.

Resin compositions with low viscosity are preferred in the apparatus disclosed above, since such compositions allow a fast recoating process to be carried out.

### Resin composition

### Composition Preparation

Examples of resin compositions according to the present invention are disclosed in the following. Table 1a and b shows the trade names, suppliers, chemical names and structures of the compounds used in said examples.

**Table 1a**

| **Trade Name** | **Supplier** | **Chemical Name** | **CAS NO.** | **Structure** |
|---|---|---|---|---|
| Sartomer 348 L | Cray Valley / Sartomer | Bisphenol A, ethoxylated, dimethacrylate | 41637-38-1 | 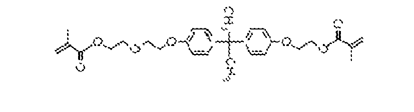 |
| Sartomer 833s | Cray Valley / Sartomer | Octahydro-4,7-methano-1H-Indenediyl)bis(methylene) diacrylate | 42594-17-2 | 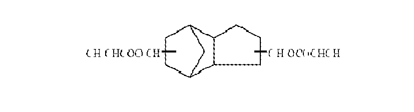 |
| Sartomer 610 | Cray Valley / Sartomer | Polyethylene glycol (600) diacrylate | 26570-48-9 | 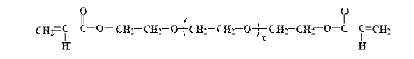 |
| Sartomer 494 | Cray Valley / Sartomer | Alkoxylated Pentaerythritol Tetraacrylate | EPA Accession #175305 | 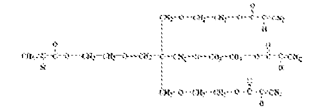 |
| Sartomer CN981 | Cray Valley / Sartomer | aliphatic urethane diacrylate oligomer | Proprietary | |
| Urethane A | Huntsman | aliphatic urethane diacrylate oligomer | Proprietary | 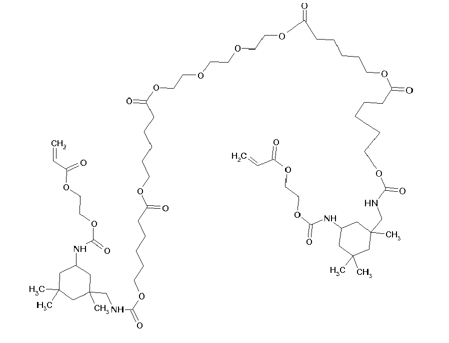 |
| Urethane B | Huntsman | aliphatic urethane diacrylate oligomer | Proprietary | 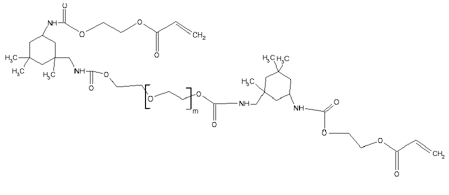 |
| Ebecryl 270 | Cytec | aliphatic urethane diacrylate oligomer | Proprietary | |
| ACMO | Rahn | Acryloyl Morpholine | 5117-12-4 | 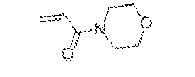 |
| Lucirin TPO | BASF | Diphenyl(2,4,6-trimethylbenzoyl)phosphi ne oxide | 75980-60-8 | 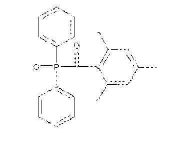 |
| Irgacure 184 | Ciba | 1-hydroxy-cyclohexyl-phenyl-ketone | 947-19-3 | 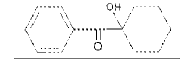 |
| Irgacure 369 | Ciba | 2-benzyl-2-dimethylamino-4'-morpholinobutyrophenon e | 119313-12-1 | 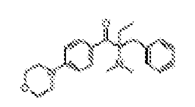 |

**Table 1 b**

| **Trade Name** | **Supplier** | **Chemical Name** | **CAS NO.** | **Structure** |
|---|---|---|---|---|
| Albidur XP 1/0767 | Nanoresins AG | 40% silicone particles n 60% alkoxylated pentaerythritol | 79-10-7 | |
| | | tetraacrylate | | |
| Triphenylphosphite | Merck | Phosphorous acid triphenyl ester | 101-02-0 | 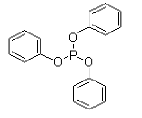 |
| Borchi Gol LAC 80 | OMG | Polyether-modified methylpolysiloxane | proprietary | |
| Byk 017 | BYK-Chemie GmbH | Compound of hydrophobic particles and polysiloxanes | mixture | |
| Byk A-500 | BYK-Chemie GmbH | Solution of foam destroying polymers, silicone free | mixture | |
| Byk A-530 | BYK-Chemie GmbH | Solution of foam destroying polymers and polysiloxane | mixture | |
| Byk A-535 | BYK-Chemie GmbH | Solution of foam destroying polymers, silicone free | mixture | |
| C-400 BK | Negami Chemicals | Cross linked urethane beads | mixture | |
| Tinuvin 123 | Ciba | bis (1-octyloxy-2,2,6,-tetramethyl-4-piperidyl) sebacate | 129757-67-1 | 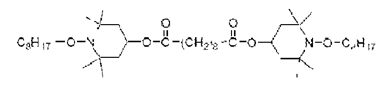 |

Examples of used component A are Urethane A, Urethane B, Sartomer CN 981 or Ebecryl 270.

Such compounds exhibit a structure according to the following general formula (1):

CH₂=CH-COO-(CH₂)n-COO-NH-**DI**-NH-COO-**L** -COO-NH-**DI**-NH-COO-(CH₂)n-COO-CH=CH₂

whereby n is an integer.

Urethane A, Urethane B, Sartomer CN 981 or Ebecryl 270 are urethane aliphatic diacrylates exhibiting an alkylene group (CH₂)n between the carbamate group and the acrylate group and exhibiting a group **DI**, which is a rest of the reaction of a diisocyanate precursor O=C=N-**DI**-N=C=O, for example isophorone diisocyanate (IPDI) or hexamethylene diisocyanate (HDI). (see D. Randall, the Polyurethane Book, Wiley, 2002, ISBN 0-470-85041-8)
Urethane A, Urethane B, Sartomer CN 981 or Ebecryl 270 exhibit also a linear aliphatic linking chain group **L**, which may contain ether or ester groups.
If **L** comprises more than one ether group, the urethane acrylate is defined as a polyether acrylate. (Urethane A, Urethane B, Sartomer CN 981 or Ebecryl 270)
If **L** comprises more than one ester group, the urethane acrylate is defined as a polyester acrylate. (Urethane A, Sartomer CN 981)
Urethane A is an aliphatic polyether and polyester urethane diacrylate, whose molecule exhibits both ether and ester group.
Urethane A is was prepared according to the following procedure:
Polyethyleneglycol with defined molecular weight was mixed in presence of a catalyst with caprolactone , the product of this reaction was condensed with a diisocyanate (isophoronediisocyanate) and then end capped with hydroxyethylacrylate. (See Barreau, Ph. et al., J. Polym. Sci.: Part B: 1999, Vol. 37, 919-937 and Ferruti, P. et al., Biomacromolecules 2003, 4, 181-188)

CN 981 is a commercial aliphatic polyether and polyester urethane diacrylate, with similar structure and the same molecular weight (MW) and polydispersity (PDI) as Urethane A.

Urethane B is an aliphatic polyether urethane diacrylate, whose molecule exhibits ether but no ester group in the linear aliphatic linking chain group L.
Urethane B was prepared according to the following procedure:
A polyethyleneglycol with defined molecular weight was condensed with a diisocyanate (isophorone diisocyanate), the product of the reaction was then end capped with hyd roxyethylacrylate.
Ebecryl 270 is a commercial aliphatic polyether urethane diacrylate, with similar structure and the same molecular weight (MW) and polydispersity (PDI) as Urethane B.
Urethane A, Urethane B, Sartomer CN 981 or Ebecryl 270 were characterized by Gel permeation chromatography (GPC). GPC is a chromatographic technique that is commonly used to determine average molecular weights (MW) of oligomeric and polymeric substances by comparison with polymeric standards of known MW and low polydispersity index (PDI). The ratio between the weight-averaged and the number-averaged MW is defined as polydispersity index or polydispersity (PDI) and describes numerically how broad is the distribution of the molecular weights of the individual polymer chains in a sample. The molecular weight as well as the polydispersity index were determined by GPC analysis according to OECD 118 guidelines, under the following conditions given in Table 2 a:

**Table 2 a**

| | | | |
|---|---|---|---|
| Instrument | : | PL-GPC 50Plus | |
| Oven Temperature | : | **35** | **°C** |
| Columns | : | **PIgeI MIXED E+Guard MIXED E** | |
| Detector | : | RI | |
| Flow rate | : | 1 | mL /min |
| Solvent | : | **THF** | |
| Injection volume | : | 100 | uL |
| Concentration | : | ∼4 | mg /mL |
| Calibration STD | : | **PS Standard** (162-29'510 MW) | |
| Calibration curve | : | Polynomial order 3 | |

The measured average molecular weight (MW) and polydispersity index (PDI) are shown in Table 2 b. Urethane A and CN 981 exhibit a molecular weight of 1900 g/mole and a polydispersity of 1.3. Urethane B and Ebecryl 270 exhibit a molecular weight of 2100 g/mole and a polydispersity of 1.7.

**Table 2 b**

| **Product name** | **MW (g/mole)** | **PDI** | **Comments** |
|---|---|---|---|
| CN 981 | 1900 | 1.3 | Monomodal distribution |
| Ebecryl 270 | 2100 | 1.7 | At least tri-modal distribution with residual low MW component (PDI refers to all detectable peaks) |
| Urethane A | 1900 | 1.3 | Monomodal distribution |
| Urethane B | 2100 | 1.7 | At least tri-modal distribution with residual low MW component (PDI refers to all detectable peaks) |

ACMO is a monofunctional acrylamide with the function of reactive diluent, characterized by a low viscosity, around 12 mPa·s at 30°C , well below 100 mPa·s at 30°C. (component B)

Lucirin TPO, Irgacure 184 and Irgacure 369 are photoinitiators (component C).

Sartomer 494 is Alkoxylated Pentaerythritol Tetraacrylate (component D). Alkoxylated Pentaerythritol Tetraacrylate is also contained in Albidur XP 1/0767.

Sartomer 348 L, Sartomer 833s, Sartomer 610 are difunctional acrylates or methacrylates (component E)

Albidur XP 1/0767 is a filler comprising 40 wt% silica based core shell nanoparticles (component F) dispersed in 60 wt% alkoxylated pentaerythritol tetraacrylate.

Triphenylphosphite is an oxygen scavenger.

The other components listed in Table 1 b are flow and wetting additives.

Compositions in the examples were prepared according to the following procedure:
- Mixing the photoinitiators in the monofunctional reactive diluent (ACMO) at 60°C until complete dissolution;
- Adding the other components at Room Temperature (23°C);
- Adding the additives (core shell particles, defoaming agents, dyes);
- Mixing with High Speed Disperser for 20 min.

Tables 3a, 3b and 3c show different examples of photocurable resin compositions according to the present invention. They have been obtained by mixing the ingredients listed in Table 1 a and 1 b. A Control composition (Example 5) without any component A (urethane acrylate) is represented with other inventive compositions. The measured viscosity and photosensitivity of said resin compositions, the speed of the scanning bar used for curing the corresponding resins and the mechanical properties of the three-dimensional objects obtained after curing have been indicated in Table 5a, 5b and 5c for each resin composition.

### Curing / Production of Test Parts

Formulations were cured using the Stereo lithography apparatus SA, with the exposure system described above.
The photo curable composition is placed in a vat designed for use with the Stereo lithography apparatus SA at about 30°C. The surface of the composition, either in its entirety or in accordance with a predetermined pattern, is irradiated with an Ultraviolet/Visible light source so that a layer of desired thickness is cured and solidified in the irradiated area. The scanning bar to which the exposure system (ES) is mounted is driven at a speed reported in Table 5a, 5b and 5c, in order to cure the photocurable resin.

Cure of the samples for the mechanical tests in the Stereo lithography apparatus SA was carried out with the scanning bar moving between 14 mm/s and 62 mm/s (cure speed), in a multicavity vat system, using standard perforated building plates to produce mechanical test parts.
The power flux of the light focused onto the illumination area was around 25 mW/cm². The accumulated exposure time was around 0.68 s. The Stereo lithography apparatus described SA above can, however, delivery power fluxes at the illumination area from 5 mW/cm² to 60 mW/cm².

A new layer of the photo curable composition is formed on the solidified layer. The new layer is likewise irradiated over the entire surface or in a predetermined pattern. The newly solidified layer adheres to the underlying solidified layer. The layer formation step and the irradiation step are repeated until a "green model" of multiple solidified layers is produced.

A "green model" is a three-dimensional article initially formed by the stereo lithography process of layering and photo curing, where typically the layers are not completely cured. This permits successive layers to better adhere by bonding together when further cured. "Green strength" is a general term for mechanical performance properties of a green model, including modulus, strain, strength, hardness, and layer-to-layer adhesion. For example, green strength may be reported by measuring flexural modulus (according to ASTM D 790). An object having low green strength may deform under its own weight, or may sag or collapse during curing.
The green model is then washed in Isopropanol and subsequently dried with compressed air. The dried green model is next postcured with UV radiation in a postcure apparatus ("PCA") with defined energies (UVA+UVB+UVV) > 6 J cm⁻⁻². "Postcuring" is the process of reacting a green model to further cure the partially cured layers. A green model may be postcured by exposure to heat, actinic radiation, or both.

Parts produced in this way were then washed in isopropanol and finally cured in a Post Cure Apparatus (PCA) with defined energies (UVA+UVB+UVV) > 6 J cm⁻⁻². Mechanical test properties were measured on the post cured parts after conditioning 1-5 days at 23°C and 40% - 50% room humidity.

### Viscosity Measurement

The viscosity of the liquid mixtures is determined at 30°C, using a Rheostress RS80 Rheometer.

### Mechanical Test Procedures

The mechanical properties of the produced samples have been measured according to the corresponding ISO Standards, as listed in Table 4.

**Table 4**

| | ISO standard |
|---|---|
| Tensile properties: elongation to break, strength, modulus | ISO 527-2/93 |
| Flexural properties: Maximum strength, modulus | ISO 178/01 |
| Bend Notched Impact Resistance: Fracture toughness (G1c), stress intensity coefficient (K1c) | ISO 13586/03 |
| HDT at 0.45 MPa : Heat deflection temperature under 0.45 MPa load | ISO 75-2/04 |
| Glass transition temperature (Tg) measured by Dynamic Mechanical Analysis (DMA) | ISO 6721-7/96 |

### Shrinkage measurement by H-Bench

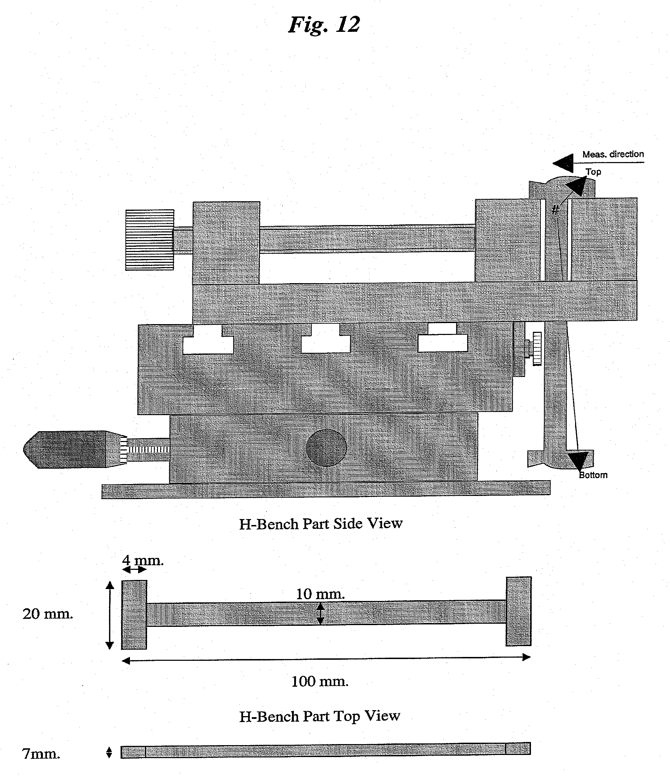

Differential shrinkage by H-Bench measurement was carried out with the equipment depicted in Fig. 12 at 23°C / 50% relative humidity.
With reference to Figure 12, a part is built using the Stereo lithography apparatus SA, which resembles an "H" with an elongated central portion, such that the two vertical parts of the H are built upright in the vertical direction. This part is then held loosely as shown in the apparatus in Fig. 12 and a Focodyn laser profilometer is used to measure the surface profile. Differential shrinkage is the distance in microns between the maximum and minimum points of the measured surface profile. Dimensions of the "H" part are also shown in Figure 12.

### Determination of Photosensitivity (Dp, Ec)

The photosensitivity of the compositions is determined using "stripes" of cured composition. In this determination, single-layer test specimens are produced using the Stereo lithography apparatus SA with different cure speeds, and hence different amounts of energy. The layer thicknesses of these stripes are then measured. The plotting of the resulting layer thickness on a graph against the logarithm of the irradiation energy used gives the so-called "working curve". The slope of this curve is termed Dp (depth of Penetration, in microns). The energy value at which the curve passes through the x-axis is termed Ec (Critical Exposure Energy, in mJ/cm²). (Cf. P. Jacobs, Rapid Prototyping and Manufacturing, Soc. Of Manufacturing Engineers, 1992, pp 270 ff.)

### Results of the characterization tests

Table 5a, 5b and 5 c shows the measured viscosity and photosensitivity of the photocurable resin compositions in Table 3a, 3b and 3c, the speed of the scanning bar used to cure the resins in the Stereo lithography apparatus SA, and the mechanical and thermal properties of the three dimensional objects produced by curing said resins in the Stereo lithography apparatus SA.

In order to allow the recoating process with the Stereo lithography apparatus SA, the photocurable resin composition must exhibit a viscosity lower than 1200 mPa·s at 30°C. This condition is fulfilled for all photocurable resins presented in Table 3a, 3b and 3c.

In order to allow an acceptable curing speed on the Stereo lithography apparatus SA, the photocurable resin composition must exhibit a high photosensitivity, i.e. a Critical Exposure Energy (Ec) less than 4 mJ/cm². This condition is also fulfilled for all photocurable resins presented in Table 3a, 3b and 3c.

In order to achieve acceptable thermal properties of the produced three dimensional objects OB, the heat deflection temperature (HDT) at 0.45 MPa of the produced three dimensional objects OB must be higher than 45°C and the glass transition temperature (Tg) of the produced three dimensional objects OB must be higher than 60°C. This condition is also fulfilled for all photocurable resins presented in Table 3a, 3b and 3c.

In order to achieve an acceptable toughness of the produced three dimensional objects OB, K1c of the produced three dimensional objects OB must be higher than 0.6 MPa√m and G1c of the produced three dimensional objects OB must be higher than 200 J m⁻². Otherwise the produced three dimensional objects OB exhibit an undesired brittle behaviour. This condition is fulfilled for all photocurable resins presented in Table 3a, 3b and 3c, except for the resin of comparative example 5, which contains no urethane acrylate (component A).

In order to achieve the most preferred mechanical properties of the produced three dimensional objects OB, the tensile elastic modulus of the produced three dimensional objects OB must be higher than 1200 MPa and the tensile strength of the produced three dimensional objects OB must be higher than 25 MPa. This condition is fulfilled for all photocurable resins presented in Table 3a, 3b and 3c, except for the resins of example 6 and 7, which contain aliphatic urethane acrylates (component A) which are not polyester acrylates and are characterized by a high polydispersity (> 1.4).
The resins of example 1, 2, 3, 4 and 8, which contain core shell nanoparticles, exhibit surprisingly an exceptional toughness of the produced three dimensional objects OB, whereby K1c of the produced three dimensional objects OB is higher than 0.8 MPa√m, G1c of the produced three dimensional objects OB is higher than 400 J m⁻² and the elongation at break of the produced three dimensional objects OB is higher than 7%.

The resins according to the invention point out surprisingly that they may form performing three dimensional objects exhibiting good mechanical properties, high tensile modulus, high tensile strength, high toughness, low curling and shrinkage. They exhibit a surprisingly high photosensitivity and low viscosity and are therefore in particular very well suited to be cured with an acceptable speed in a stereo lithography apparatus SA as described above, supplying low intensity incoherent radiation to the illumination area IA.

**Table 3 a**

| **Resin Composition** | | **Example 1** | **Example 2** | **Example 3** | **Example 4** | **Comparative Example 5** |
|---|---|---|---|---|---|---|
| | | | | | | |
| (Meth)acrylate | SR348L | | 29 40%wt | 29 40%wt | 27 68%wt | 77 97%wt |
| | SR833S | 0 57%wt | | | | |
| | SR610 | | 11 30%wt | 11 30%wt | 10 64%wt | |
| | SR494 | | 10 00%wt | 10 00%wt | 9 42%wt | |
| Urethane Acrylate | Ebecryl 270 (1 6<PDI<1 8) | | | | | |
| | CN981 (1 2<PDI<1 3) | 47 74%wt | 29 60%wt | | 27 87%wt | |
| | Urethane A (1 2<PDI<1 3) | | | 29 60%wt | | |
| | Urethane B (1 6<PDI<1 8) | | | | | |
| Reactive diluent | ACMO | 37 67%wt | 14 20%wt | 14 20%wt | 15 73%wt | 14 10%wt |
| Photoinitiator | Irgacure 184 | 0 83%wt | | | | |
| | Irgacure 369 | | 2 00%wt | 2 00%wt | | 1 88%wt |
| | Lucirin TPO | 2 48%wt | | | 141%wt | |
| Filler | Albidur XP1/0767 | 9 60%wt | 2 80%wt | 2 80%wt | 6 59%wt | 4 95%wt |
| Additive | Triphenyl phosphite | 103%wt | 0 50%wt | 0 50%wt | 0 47%wt | 1 00%wt |
| | BorchiGol LAC 80 | 0 02%wt | 0 04%wt | 0 04%wt | 0 04%wt | 0 10%wt |
| | Byk 017 | 0 02%wt | | | | |
| | Byk A-500 | 0 04%wt | | | | |
| | Byk A-535 | | 0 16%wt | 0 16%wt | 0 15%wt | |
| | Byk A-530 | | | | | |
| | Art Pearl C-400 BK | | | | | |
| | Tinuvin 123 | | | | | |
| Total % weight | | 100 00%wt | 100 00%wt | 100 00%wt | 100 00%wt | 100 00%wt |

**Table 3 b**

| **Resin Composition** | | **Example 6** | **Example 7** | **Example 8** | **Example 9** | **Example 10** |
|---|---|---|---|---|---|---|
| | | | | | | |
| (Meth)acrylate | SR348L | 29 40%wt | 29 40%wt | | | |
| | SR833S | | | 9 90%wt | 9 90%wt | 9 90%wt |
| | SR610 | 11 30%wt | 11 30%wt | | | |
| | SR494 | 10 00%wt | 10 00%wt | | | |
| Urethane Acrylate | Ebecryl 270 (1 6<PDI<1 8) | 29 60%wt | | | | |
| | CN981 (1 2<PDI<1 3) | | | 39 58%wt | 43 17%wt | 41 78%wt |
| | Urethane A (1 2<PDI<1 3) | | | | | |
| | Urethane B (1 6<PDI<1 8) | | 29 60%wt | | | |
| Reactive diluent | ACMO | 14 20%wt | 14 20%wt | 39 58%wt | 43 17%wt | 41 78%wt |
| Photoinitiator | Irgacure 184 | | | | | |
| | Irgacure 369 | 2 00%wt | 2 00%wt | | | |
| | Lucirin TPO | | | 2 67%wt | 2 67%wt | 2 97%wt |
| Filler | Albidur XP1/0767 | 2 80%wt | 2 80%wt | 7 03%wt | | |
| Additive | Triphenyl phosphite | 0 50%wt | 0 50%wt | 0 99%wt | 0 99%wt | 0 99%wt |
| | BorchiGol LAC 80 | 0 04%wt | 0 04%wt | | | |
| | Byk 017 | | | | | |
| | Byk A-500 | | | | | |
| | Byk A-535 | 0 16%wt | 0 16%wt | | | |
| | Byk A-530 | | | 0 15%wt | | |
| | Art Pearl C-400 BK | | | | | 2 48%wt |
| | Tinuvin 123 | | | 0 10%wt | 0 10%wt | 0 10%wt |
| Total % weight | | 100 00%wt | 100 00%wt | 100 00%wt | 100 00%wt | 100 00%wt |

**Table 3 c**

| **Resin Composition** | | **Example 11** | **Example 12** | **Example 13** |
|---|---|---|---|---|
| | | | | |
| (Meth)acrylate | SR348L | | | |
| | SR833S | 5 00%wt | 4 70%wt | 4 50%wt |
| | SR610 | | | |
| | SR494 | 5 00%wt | 10 00%wt | 15 00%wt |
| Urethane Acrylate | Ebecryl 270 (1 6<PDI<1 8) | | | |
| | CN981 (1 2<PDI<1 3) | 43 00%wt | 40 65%wt | 38 25%wt |
| | Urethane A (1 2<PDI<1 3) | | | |
| | Urethane B (1 6<PDI<1 8) | | | |
| Reactive diluent | ACMO | 43 00%wt | 40 65%wt | 38 25%wt |
| Photoinitiator | Irgacure 184 | | | |
| | Irgacure 369 | | | |
| | Lucirin TPO | 3 00%wt | 3 00%wt | 3 00%wt |
| Filler | Albidur XP1/0767 | | | |
| Additive | Triphenyl phosphite | 1 00%wt | 1 00%wt | 1 00%wt |
| | BorchiGol LAC 80 | | | |
| | Byk 017 | | | |
| | Byk 500 | | | |
| | Byk A-535 | | | |
| | Byk A-530 | | | |
| | Art Pearl C-400 BK | | | |
| | Tinuvin 123 | | | |
| Total % weight | | 100 00%wt | 100 00%wt | 100 00%wt |

**Table 5 a**

| **Resin Properties** | | **Example 1** | **Example 2** | **Example 3** | **Example 4** | **Comparative Example 5** |
|---|---|---|---|---|---|---|
| | | | | | | |
| Viscosity at 30° C | MPa s | 800-850 | 600-700 | 600-700 | 680-740 | 300-350 |
| Flexural modulus | MPa | 1630 | 1550 | 1500 | 1865 | 2300 |
| Flexural strength | MPa | 57 5 | 45 | 51 | 56 | 75 |
| Tensile modulus | MPa | 1650 | 1450 | 1416 | 1890 | 2400 |
| Tensile strength | MPa | 33 5 | 31 | 33 5 | 39 | 50 |
| Elongation at break | % | 21 5 | 85 | 82 | 10 | 3.5 |
| K1c | MPa√m | >2 | 0 97-1 03 | 0 99-1 06 | 0 9 | 0.5 |
| G1c | Jm⁻² | >2000 | 620 | 640 | 425 | 80 |
| HDT (045 MPa) | ° C | 46 3 | 50 5 | 51 6 | 57 5 | 90 5 |
| Tg (DMA) | ° C | 71 | 66 | 65 | 73 | 144 |
| Scanning Bar Speed | mm/s | 62 | 14-18 | 14-18 | 22 | 17-19 |
| Ec | mJ/cm² | 0 2 | 12 2 | 12 2 | 1 2 | 1 |
| Dp | microns | 88 | 220 | 220 | 166 | 156 |
| Shrinkage | microns | | | | 120--220 | 180-210 |

**Table 5 b**

| **Resin Properties** | | **Example 6** | **Example 7** | **Example 8** | **Example 9** | **Example 10** |
|---|---|---|---|---|---|---|
| | | | | | | |
| Viscosity at 30° C | MPa s | < 1200 | < 1200 | < 1200 | < 1200 | < 1200 |
| Flexural modulus | MPa | **975** | **950-1000** | 1790 | 1775 | 1030 |
| Flexural strength | MPa | 37 | 35-39 | 73 | 75 | 31 |
| Tensile modulus | MPa | **941** | **900-950** | 2005 | 1950 | 1267 |
| Tensile strength | MPa | **23** | **20-25** | 44 | 36 | 25 5 |
| Elongation at break | % | 52 | 5-5 5 | 8 | **2.3** | 14 1 |
| K1c | MPa√m | **0.7** | **0.65-0.7** | 1 26 | 094 | 1 03 |
| G1c | Jm⁻² | **438** | **400-450** | 845 | **382** | 1228 |
| HDT (045 MPa) | ° C | 55 8 | 55-56 | 54 | 52 1 | 45 4 |
| Tg (DMA) | ° C | 81 | 80-85 | 70 | 71 | 66 |
| Scanning Bar Speed | mm/s | 25 | 25 | 53 | 44 | 31 |
| Ec | mJ/cm² | 1 | 1 | 0 3 | 0 5 | 0 4 |
| Dp | microns | 172 | 172 | 98 | 149 | 87 |

**Table 5 c**

| **Resin Properties** | | **Example 11** | **Example 12** | **Example 13** |
|---|---|---|---|---|
| | | | | |
| Viscosity at 30° C | MPa s | < 1200 | < 1200 | < 1200 |
| Flexural modulus | MPa | 2167 | 2092 | 2415 |
| Flexural strength | MPa | 89 | 83 1 | 95 4 |
| Tensile modulus | MPa | 2217 | 2184 | 2369 |
| Tensile strength | MPa | 43 | 50 3 | 55 4 |
| Elongation at break | % | **2.4** | 5 8 | 5 3 |
| K1c | MPa√m | 091 | 0827 | 0844 |
| G1c | Jm⁻² | **345** | **267** | **290** |
| HDT (045 MPa) | ° C | 55 7 | 55 3 | 60 6 |
| Tg (DMA) | ° C | 79 1 | 75 | 77 |
| Scanning Bar Speed | mm/s | 41 | 42 | 43 |
| Ec | mJ/cm² | 0 8 | 0 8 | 0 7 |
| Dp | microns | 137 | 138 | 131 |

## Claims

1. System comprising:
(a) an apparatus for producing a three-dimensional object from a light-sensitive material, said apparatus comprising:
an exposure system (ES) with an illumination source,
a control unit (CU),
whereby said exposure system (ES) comprises:
at least one spatial light modulator (SLM) with a plurality of individually controllable light modulators (LM),
input optics (IO) optically coupled to said at least one spatial light modulator (SLM),
output optics (OO) optically coupled to said at least one spatial light modulator (SLM),
wherein said input optics (IO) and output optics (OO) facilitates transmission of light emitted from said illumination source via said individually controllable light modulators (LM) of said spatial light modulator (SLM) to an illumination area (IA),
wherein said spatial light modulator (SLM) enables an establishment of a pattern of the light transmitted through said input optics (IO), according to control signals originating from said control unit (CU),
wherein said output optics (OO) enable focusing of the pattern of light from said at least one spatial light modulator (SLM) on an illumination area (IA); and
(b) a photocurable resin composition comprising:
(A) at least one urethane acrylate or methacrylate component, or any mixture thereof;
(B) at least one monofunctional acrylate, methacrylate, vinylamide, acrylamide or methacrylamide component, preferably with a viscosity below 100 mPa·s at 30°C, or any mixture thereof;
(C) at least one photo initiator, or any mixture thereof.

2. A system according to claim 1, wherein the apparatus comprises a scanning bar to which the exposure system (ES) is mounted and/or wherein the distance d between the output optics (OO) and the illumination area (IA) is between 0.5 and 20 mm and/or wherein the illumination source generates incoherent light.

3. A system according to any of the preceding claims, wherein the urethane acrylate or methacrylate component (A) is an aliphatic polyester diacrylate or dimethacrylate with average molecular weight (MW) between 400 and 3000 g/mol and preferably with a polydispersity (PDI) below 1.4, or any mixture thereof.

4. A system according to any of the preceding claims, wherein the urethane acrylate or methacrylate component (A) is produced by reacting a polyalkylene glycol, preferably a polyethylene glycol, with caprolactone, isophorone diisocyanate and an hydroxyalkylacrylate, preferably hydroxyethylacrylate, and the monofunctional component (B) is an acrylamide or methacrylamide or any mixture thereof, preferably acryloylmorpholine

5. A system according to any of the preceding claims, wherein the resin composition comprises:
(A) 20 - 60 % by weight of the urethane acrylate or methacrylate component A;
(B) 10 - 70 % by weight of the monofunctional acrylate, methacrylate, vinylamide, acrylamide or methacrylamide component B;
(C) 0.1 - 10 % by weight of the photo initiator C;
(D) 1 - 20 % by weight of at least a tetrafunctional acrylate or methacrylate component, or any mixture thereof;
(E) optionally 0.1 - 50 % by weight of a difunctional acrylate or methacrylate component, or any mixture thereof, preferably a polyethylene glycol diacrylate or an ethoxylated bisphenol dimethacrylate, or tricyclodecane dimethanol diacrylate, or any mixture thereof;
based on the total weight of the resin composition.

6. A system according to any of the preceding claims, wherein the resin composition comprises:
(A) 20 - 50 % by weight of the urethane acrylate or methacrylate component A;
(B) 10 - 50 % by weight of the monofunctional acrylate, methacrylate, vinylamide, acrylamide or methacrylamide component B;
(C) 0.5 - 7 % by weight of the photo initiator C;
(D) 1 - 20 % by weight of at least one tetrafunctional acrylate or methacrylate component, or any mixture thereof, preferably ethoxylated pentaerythritol tetraacrylate;
(E) 0.5 - 45 % by weight of a difunctional acrylate or methacrylate component, or any mixture thereof, preferably a polyethylene glycol diacrylate or an ethoxylated bisphenol dimethacrylate, or a tricyclodecane dimethanol diacrylate, or any mixture thereof;
based on the total weight of the resin composition.

7. A system according to any of the preceding claims wherein the resin composition additionally comprises 0.1 to 20 %, preferably 1 to 10% by weight of core shell nanoparticles, based on the total weight of the resin composition.

8. A photocurable resin composition comprising:
(A) at least one aliphatic polyester urethane acrylate or methacrylate component with average molecular weight (MW) between 400 and 3000 g/mol and preferably with a polydispersity (PDI) below 1.4, or any mixture thereof;
(B) at least one monofunctional acrylate, methacrylate, vinylamide, acrylamide or methacrylamide component, preferably with a viscosity below 100 mPa·s at 30°C, or any mixture thereof;
(C) at least one photo initiator, or any mixture thereof.

9. A resin composition according to claim 8, wherein the urethane acrylate or methacrylate component (A) is produced by reacting a polyalkylene glycol, preferably a polyethylene glycol, with caprolactone, isophorone diisocyanate and an hydroxyalkylacrylate, preferably hydroxyethylacrylate, and the monofunctional component (B) is an acrylamide or methacrylamide or any mixture thereof, preferably acryloylmorpholine.

10. A resin composition according to claim 8 or 9 comprising:
(A) 20 - 60 % by weight of the urethane acrylate or methacrylate component A;
(B) 10 - 70 % by weight of the monofunctional acrylate, methacrylate, vinylamide, acrylamide or methacrylamide component component B;
(C) 0.1 - 10 % by weight of the photo initiator C;
(D) 1 - 20 % by weight of a tetrafunctional acrylate or methacrylate component, or any mixture thereof;
(E) optionally 0.1 - 50 % by weight of a difunctional acrylate or methacrylate component, or any mixture thereof, preferably a polyethylene glycol diacrylate or an ethoxylated bisphenol dimethacrylate, or a tricyclodecane dimethanol diacrylate, or any mixture thereof;
based on the total weight of the composition.

11. A resin composition according to claim 8 or 9 or 10 comprising at least:
(A) 20 - 50 % by weight of the urethane acrylate or methacrylate component A;
(B) 10 - 50 % by weight of the monofunctional acrylate, methacrylate, vinylamide, acrylamide or methacrylamide component component B;
(C) 0.5 - 7 % by weight of the photo initiator C;
(D) 1 - 20 % by weight of a tetrafunctional acrylate or methacrylate component, or any mixture thereof, preferably ethoxylated pentaerythritol tetraacrylate;
(E) 0.5 - 45 % by weight of a difunctional acrylate or methacrylate component, or any mixture thereof, preferably a polyethylene glycol diacrylate or an ethoxylated bisphenol dimethacrylate, or a tricyclodecane dimethanol diacrylate, or any mixture thereof;
based on the total weight of the resin composition.

12. Method for manufacturing a 3-dimensional object (OB) with a system according to any of the claims 1 to 7 and/or with a resin according to any of the claims 8 to 11, comprising the steps of:
a) producing a first layer of a liquid light-sensitive material;
b) exposing said first layer to UV radiation, so as to solidify said first layer with a predetermined pattern;
c) applying a second layer of a liquid light-sensitive material onto the first solidified layer;
d) exposing said second layer to UV radiation, so as to solidify said second layer with a predetermined pattern;
e) repeating the steps a) to d) until a predetermined 3-dimensional object (OB) is formed.

13. A cured article obtained by a method according claim 12.

14. System according to any of the claims 1 to 7,
wherein the apparatus for producing a three-dimensional object from a light-sensitive material comprises at least one releasable protective window (PW) between said output optics (OO) and said illumination area (IA).

15. System according to any of the claims 1 to 7 or 14,
wherein the apparatus for producing a three-dimensional object from a light-sensitive material comprises at least one collision-preventing detection system (LBa, LBb, HSa, HSb) for detecting obstacles between the illumination area (IA) and the output optics (OO).
